# EUROPEAN PATENT APPLICATION

(11) **EP 4 108 445 A1**
(43) Date of publication of application: **28.12.2022**
(21) Application number: 21756541.5
(22) Date of filing: 16.02.2021
(51) Int. Cl.: B32B 3/30, B05D 3/04, B05D 3/10, B05D 5/06, B05D 7/24, B32B 3/28, B32B 9/00, B32B 33/00

(54) **LAMINATE AND METHOD FOR MANUFACTURING LAMINATE**

(30) Priority: 17.02.2020 JP 2020024719; 25.02.2020 JP 2020029713; 24.03.2020 JP 2020052995; 27.03.2020 JP 2020057970; 04.06.2020 JP 2020098000; 13.11.2020 JP 2020189432; 13.11.2020 JP 2020189433; 13.11.2020 JP 2020189442; 13.11.2020 JP 2020189447
(71) Applicant: Mitsubishi Chemical Corporation, Chiyoda-ku Tokyo 100-8251 (JP)
(72) Inventor: UEMATSU, Takuya, Tokyo 100-8251 (JP); YANAGIHARA, Hideto, Tokyo 100-8251 (JP); TANIYAMA, Kaori, Tokyo 100-8251 (JP); KANAI, Shinichiro, Tokyo 100-8251 (JP)
(74) Representative: Hoffmann Eitle
(86) International application number: PCT/JP2021/005714
(87) International publication number: WO 2021/166911

(57) **Abstract**

The present invention relates to a laminate. The laminate (10) includes a base material (11), and a resin layer (12) provided on at least one surface (11A) of the base material (11). The resin layer (12) is formed of a heat- or active energy ray-curable resin composition, and an outermost surface (10A) of the laminate (10) on the one surface (11A) side of the base material (11) has an unevenness containing a wrinkle structure.

## Description

### Technical Field

The present invention relates to a laminate having an unevenness on the surface thereof, and a method of manufacturing the same.

### Background Art

A technique of forming a fine unevenness on the surface of various materials has conventionally been developed.

For example, for packaging materials, it is known that an unevenness is formed in order to prevent contents from adhering to a lid member or an inner peripheral surface of a container. Further, for example, a technique of forming a fine unevenness on an optical material and increasing the cloudiness to suppress transmission or to suppress surface reflection is also known.

Regarding each of these applications, there is an optimum surface unevenness structure for each, which is formed by controlling the unevenness structure.

PTL 1 discloses a water-repellent laminate including a base material, an organic solvent-resistant sealant film layer, and an anti-adhesion layer in this order, which is characterized in that the anti-adhesion layer includes a thermoplastic resin, water-repellent fine particles and bead particles having a larger average particle size than the water-repellent fine particles.

Regarding such a laminate, it is illustrated that since the anti-adhesion layer contains two types of particles having different sizes, a peculiar unevenness structure is formed on the surface, and the anti-adhesion property of viscous contents and the water repellency may be significantly improved.

### Citation List

### Patent Literature

PTL 1: JP 2017-226199 A

### Summary of Invention

### Technical Problem

However, as disclosed in PTL 1, when the unevenness is formed by particles, it might be impossible to eliminate the falling of the particles existing near the surface. Then, for example, in the case of use for packaging materials, foreign matter was easily mixed into contents, and thus an application to others than the lid member was difficult.

Further, PTL 1 does not specifically disclose a method of controlling an unevenness structure, and thus a further improvement is required to control the unevenness structure.

Therefore, an object of the present invention is to provide a laminate having a surface unevenness, in which the surface uneven shape may be controlled, and there is no risk of the falling of particles.

### Solution to Problem

The gist of the present invention is as described in the followings [1] to [15].
[1] A laminate including a base material, and a resin layer provided on at least one surface of the base material.
   In the laminate, the resin layer is formed of a heat- or active energy ray-curable resin composition, and
   an outermost surface of the laminate on the one surface side of the base material has an unevenness containing a wrinkle structure.
[2] The laminate described in [1], in which the resin layer buckles to form the wrinkle structure.
[3] The laminate described in [1] or [2], in which a specific surface area (S/A) of the outermost surface is 1.005 or more.
[4] The laminate described in any one of [1] to [3], in which Sa (arithmetic mean roughness) of the outermost surface is 50 nm or more.
[5] The laminate described in any one of [1] to [4], in which Sz (maximum height) of the outermost surface is 4000 nm or more.
[6] The laminate described in any one of [1] to [5], in which an absolute value of Ssk (degree of deviation) of the outermost surface is 5 or less.
[7] The laminate described in any one of [1] to [6], further including a cover layer on the resin layer.
[8] The laminate described in any one of [1] to [7], in which the cover layer is either an inorganic substance-containing layer or a cover resin layer.
[9] The laminate described in [8], in which the inorganic substance-containing layer is formed of at least one selected from the group consisting of diamond-like carbon, metal, metal oxide, metal nitride, metal carbide, and composites thereof.
[10] The laminate described in [8] or [9], in which the inorganic substance-containing layer is formed of a silicon-based compound.
[11] The laminate described in any one of [7] to [10], in which the cover layer contains a fluorine-based compound on at least a surface thereof.
[12] The laminate described in any one of [1] to [11], in which the wrinkle structure includes a primary wrinkle structure, and a secondary wrinkle structure having a smaller undulation period than the primary wrinkle structure.
[13] A method of manufacturing a laminate, including:
   a step of applying a heat- or active energy ray-curable resin composition to at least one surface of a base material to form a resin layer precursor; and
   a step of further performing a surface treatment through a dry process to the resin layer precursor that is semi-cured or uncured, so as to form an unevenness containing a wrinkle structure on a surface on the one surface side of the base material.
[14] The laminate manufacturing method described in [13], in which the surface treatment is any of chemical vapor deposition, physical vapor deposition, and plasma treatment.
[15] The laminate manufacturing method described in [13] or [14], including a step of semi-curing the resin layer precursor formed by the applying, in which the surface treatment is performed to the semi-cured resin layer precursor.

### Advantageous Effects of Invention

In the present invention, it is possible to provide a laminate having a surface unevenness, in which the surface uneven shape can be controlled, and there is no risk of the falling of particles, with forming an unevenness having a wrinkle structure on an outermost surface of the laminate.

### Brief Description of Drawings

Fig. 1 is a schematic cross-sectional view illustrating an example of a laminate of the present invention;
Fig. 2 is a schematic cross-sectional view illustrating an example of the laminate of the present invention;
Fig. 3 is a schematic cross-sectional view illustrating an example of the laminate of the present invention;
Fig. 4 is a schematic view illustrating an example of the laminate of the present invention;
Fig. 5 is a schematic view illustrating an example of the laminate of the present invention;
Fig. 6 is an observation image obtained by observing an outermost surface of a laminate having an unevenness in Example 1, with a scanning microscope (SEM) at a magnification of 5000x;
Fig. 7 is an observation image obtained by observing the outermost surface of the laminate having the unevenness in Example 1, with a scanning microscope (SEM) at a magnification of 50000x;
Fig. 8 is an observation image obtained by observing an outermost surface of a laminate having an unevenness in Example 3, with a scanning microscope (SEM) at a magnification of 5000x;
Fig. 9 is an observation image obtained by observing the outermost surface of the laminate having the unevenness in Example 3, with a scanning microscope (SEM) at a magnification of 50000x;
Fig. 10 is an observation image obtained by observing an outermost surface of a laminate having an unevenness in Example 5, with a scanning microscope (SEM) at a magnification of 5000x;
Fig. 11 is an observation image obtained by observing the outermost surface of the laminate having the unevenness in Example 5, with a scanning microscope (SEM) at a magnification of 50000x;
Fig. 12 is an observation image obtained by observing an outermost surface of a laminate having an unevenness in Example 9, with a scanning microscope (SEM) at a magnification of 5000x;
Fig. 13 is an observation image obtained by observing the outermost surface of the laminate having the unevenness in Example 9, with a scanning microscope (SEM) at a magnification of 50000x;
Fig. 14 is an observation image obtained by observing an outermost surface of a laminate having an unevenness in Example 13, with a scanning microscope (SEM) at a magnification of 5000x;
Fig. 15 is an observation image obtained by observing the outermost surface of the laminate having the unevenness in Example 13, with a scanning microscope (SEM) at a magnification of 50000x;
Fig. 16 is an observation image obtained by observing an outermost surface of a laminate having an unevenness in Example 17, with a stereoscopic microscope;
Fig. 17 is an observation image obtained by observing the outermost surface of the laminate having the unevenness in Example 17, with a scanning microscope (SEM) at a magnification of 5000x;
Fig. 18 is an observation image obtained by observing the outermost surface of the laminate having the unevenness in Example 17, with a scanning microscope (SEM) at a magnification of 50000x;
Fig. 19 is an observation image obtained by observing an outermost surface of a laminate having an unevenness in Comparative Example 1, with a scanning microscope (SEM) at a magnification of 5000x; and
Fig. 20 is an observation image obtained by observing the outermost surface of the laminate having the unevenness in Comparative Example 1, with a scanning microscope (SEM) at a magnification of 50000x.

### Description of Embodiments

Next, the present invention will be specifically described on the basis of embodiments of the present invention, but the present invention is not limited to embodiments described below at all.

### «First embodiment»

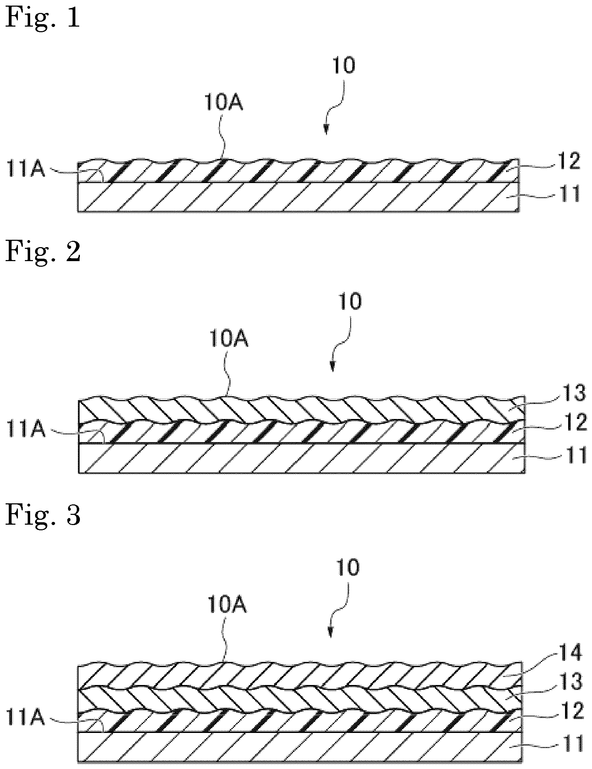

For example, as illustrated in Figs. 1 to 3, a laminate 10 according to a first embodiment of the present invention includes a base material 11, and a resin layer 12 provided on at least one surface 11A of the base material 11. The resin layer 12 is made of a heat- or active energy ray-curable resin composition.

In the laminate 10, as illustrated in Fig. 1, another layer may not be provided on the resin layer 12, and the resin layer 12 may become an outermost surface 10A of the laminate 10, on one surface 11A side of the base material 11. Further, in the laminate 10, as illustrated in Figs. 2 and 3, it is preferable that a cover layer 13 is provided on the resin layer 12, and as illustrated in Fig. 3, an over cover layer 14 may be further provided on the cover layer 13.

When the cover layer 13 is provided and the over cover layer 14 is not provided on the cover layer 13, as illustrated in Fig. 2, the cover layer 13 constitutes the outermost surface 10A of the laminate 10.

Further, when the over cover layer 14 is further provided on the cover layer 13, as illustrated in Fig. 3, the over cover layer 14 constitutes the outermost surface 10A of the laminate 10.

Further, in the laminate 10, the resin layer 12 may be formed so as to be in direct contact with the top of the base material 11, but a layer such as an adhesive layer may be appropriately provided between the resin layer 12 and the base material 11.

Hereinafter, the laminate of the present embodiment will be described in more detail. In the following description, the laminate 10, the base material 11, the resin layer 12, the cover layer 13 and the over cover layer 14 in the present embodiment may be referred to as a "laminate (I)", a "base material (I)", a "resin layer (I)", a "cover layer (I)", and an "over cover layer (I)", respectively.

### <Unevenness containing wrinkle structure>

In the laminate (I) 10, on one surface 11A side of the base material (I) 11, the outermost surface 10A of the laminate (I) 10 has an unevenness containing a wrinkle structure.

Since the unevenness containing the wrinkle structure is included, the laminate (I) 10 may be applied to various applications (adhesion prevention, light transmission, etc.) in which the fine unevenness on the surface is utilized.

For example, when a liquid-repellent material is selected as a layer constituting the outermost surface 10A of the laminate (I) 10, contents are less likely to adhere to the surface of the laminate (I), and thus an application to packaging materials is possible.

When the adhesiveness of cells, bacteria, etc. is able to be reduced by controlling the unevenness structure, an application to sanitary materials is also possible.

Furthermore, since the unevenness containing the wrinkle structure is included, good cloudiness may also be exhibited and, for example, it is possible to control the haze or light transmission of the laminate (I).

Here, the wrinkle structure has a wrinkle shape generated by buckling of the resin layer (I) 12. This shape is different from an uneven shape having many point-like protrusions, such as an uneven shape formed by particles. In the present embodiment, the unevenness is formed by buckling of the resin layer (I) itself, and thus, it is possible to form an uneven surface in which there is no risk of falling of particles. Further, since this wrinkle structure is spontaneously formed, a mold such as a transfer sheet is unnecessary.

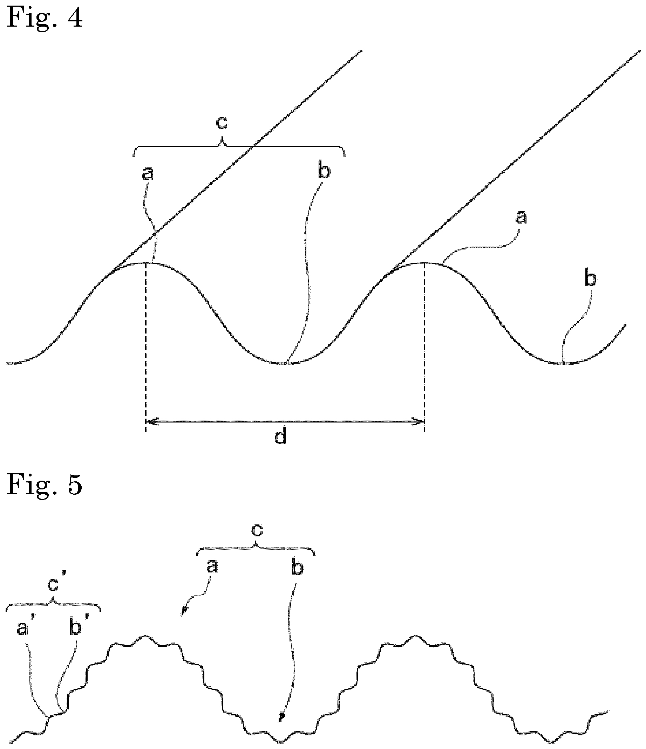

Fig. 4 illustrates a schematic view of the wrinkle structure. The wrinkle structure is composed of a plurality of undulations c, and each of the undulations c has a protrusion a and a groove b. Each of the protrusion a and the groove b has a straight line, a curved line or a shape of a combination of these. The protrusions a are irregularly formed. The protrusions a may be continuously formed, or may be discontinuously formed.

As described below, the wrinkle structure is formed along with the application of a compressive stress to the resin layer (I) 12 along a plane direction. Here, it is assumed that the compressive stress is applied in multiple directions along the plane direction, and thus the protrusions a and the grooves b are irregularly formed.

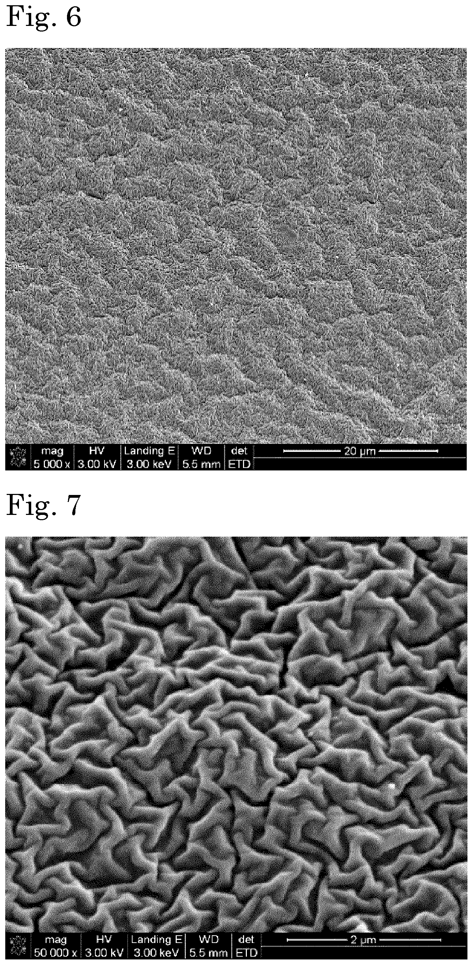

The presence or absence of the wrinkle structure may be confirmed from the outermost surface of the laminate (I), with a microscope such as a scanning electron microscope (SEM) at a magnification of, for example, about 1,000 to 100,000 times (see Figs. 6 to 12, Fig. 14, and Figs. 16 to 18). Further, the presence or absence of the wrinkle structure may also be confirmed through a three-dimensional image or the like obtained by a three-dimensional non-contact surface shape measuring machine or the like. When the wrinkle structure is included, the protrusion a and the groove b appear to form the undulation c. The undulation c may be observed in an observation image of either a square or a rectangle having each side of, for example, 3 to 500 µm, preferably about 4 to 100 µm.

The protrusions a forming the wrinkle structure are irregular, and the undulations c also appear with a micrometer-order period. Therefore, as illustrated in Figs. 6 to 12, Fig. 14, and Figs. 16 to 18, even when the undulation c formed by the protrusion a and the groove b is viewed along multiple directions (for example, three directions) such as a vertical direction, a horizontal direction, and a diagonal direction in the observation image, each of the top of the protrusion a and the bottom of the groove b appears multiple times (for example, five or more times). The period of the undulations c is not typically constant, and thus, a distance between tops of the protrusions a, a distance between bottoms of the grooves b and the like are also not constant.

As illustrated in Fig. 4, the "period of the undulations c" refers to a distance d between the vertex of a protrusion a, and the vertex of a protrusion a adjacent to a groove b adjacent to the protrusion a.

Further, in a mode of the wrinkle structure, two or more wrinkle structures (hereinafter, also referred to as a "higher-order wrinkle structure") having different undulation periods one another may be included.

For example, the wrinkle structure may include a primary wrinkle structure, and a secondary wrinkle structure having a smaller undulation period than the primary wrinkle structure.
Fig. 5 illustrates a schematic view in the case where the primary wrinkle structure and the secondary wrinkle structure are included. In Fig. 5, the primary wrinkle structure is composed of a plurality of undulations c, and the secondary wrinkle structure is composed of a plurality of undulations c' having a smaller period than the undulations c, in each of the protrusions a and the grooves b forming the plurality of corresponding undulations c.

That is, the wrinkle structure may have the primary wrinkle structure, and the secondary wrinkle structure formed by the finer protrusions a' and grooves b', in each of the relatively large protrusions a and grooves b forming the primary wrinkle structure. In this way, when the secondary wrinkle structure is included in addition to the primary wrinkle structure, it is possible to form a pseudo-fractal surface.

Whether the primary and secondary wrinkle structures are included can be determined by whether undulations appear in both of two observation images observed at different magnifications. For example, even if a ratio (Y/X) of the magnification (Y) of the other observation image to the magnification (X) of one observation image is 10 or more (Y>X), when above undulations are observed in both observation images, it can be determined that the primary and secondary wrinkle structures are present.

Further, the wrinkle structure may include a tertiary wrinkle structure having a larger undulation period than the primary wrinkle structure, in addition to the primary wrinkle structure, and the secondary wrinkle structure having a smaller undulation period than the primary wrinkle structure.

Whether the primary, secondary and tertiary wrinkle structures are included may be determined by whether undulations appear in all of three observation images observed at different magnifications. For example, even if a first observation image, a second observation image, and a third observation image have the magnification (X), the magnification (Y), and the magnification (Z) in which 10X≤Y and 10Y≤Z, when above undulations are observed in all observation images, it can be determined that the primary, secondary and tertiary wrinkle structures are present.

The fact that the unevenness of the outermost surface 10A of the laminate (I) 10 has the spontaneously formed wrinkle structure appears in, for example, the value of Ssk (skewness).

Ssk is a parameter indicating the degree of deviation of the unevenness on the surface. This degree of deviation Ssk represents a cubic mean of Z(x, y) on the reference plane made dimensionless by the cube of the root mean square height Sq, and means the skewness. This is a numerical value indicating the symmetry of the mountain portion and the valley portion around the average plane. Therefore, the case where the degree of deviation Ssk<0 means that the deviation is downward with respect to the average line, that is, there are more concave valley portions than convex mountain portions. Meanwhile, the case where Ssk>0 means that the deviation is upward with respect to the average line, that is, there are more convex mountain portions than concave valley portions. Then, the case where the degree of deviation Ssk=0 means a symmetric state with respect to the average line (normal distribution).

The wrinkle structure included in the outermost surface 10A of the laminate (I) 10 is a wrinkle shape formed by buckling of the resin layer (I) 12. Therefore, the symmetry between convex mountain portions and concave valley portions is higher than in the uneven shape formed by particles. Thus, it may be thought that the Ssk of the wrinkle structure included in the laminate (I) 10 becomes a value close to 0 as compared to the Ssk of the uneven shape formed by particles.

From this point of view, the absolute value of the Ssk of the outermost surface 10A of the laminate (I) 10 is preferably 5 or less, more preferably 3 or less, further preferably 1 or less, still further preferably 0.8 or less. Above all, it is preferably 0.5 or less, more preferably 0.3 or less, further preferably 0.1 or less.

The Ssk is a parameter based on ISO25178, and may be calculated by, for example, the following method.

By using a three-dimensional non-contact surface shape measuring machine (VertScan 2.0 R5200G manufactured by Ryoka Systems Inc.), measurement is performed with a device CCD camera SONY HR-50 1/3 inch (objective lens x10, wavelength filter 530 nm white), at a measurement mode; Wave, measurement area: 469.17 µm×351.89 µm. Then, through attached analysis software (VS-Viewer Version 5.1.3), waviness components are removed from the photographing screen by polynomial quartic approximation plane correction. Next, interpolation processing (complementary processing on pixels for which height data could not be acquired, with height data calculated from surrounding pixels) is performed so as to perform the calculation.

The outermost surface 10A of the laminate (I) preferably has a specific surface area (S/A) of 1.005 or more. The specific surface area set as 1.005 or more means that the surface area is sufficiently increased due to the wrinkle structure. Therefore, in an optical application, cloudiness is also likely to be exhibited, and then it is possible to adjust the haze value of the laminate (I) by adjusting the specific surface area.

From this point of view, the specific surface area (S/A) is more preferably 1.01 or more, further preferably 1.05 or more, still further preferably 1.1 or more.

Further, the specific surface area (S/A) is not particularly limited, but is preferably 2 or less, more preferably 1.7 or less, further preferably 1.5 or less in order to prevent the protrusions of the wrinkle structure from becoming too high and the structural strength from being reduced.

The specific surface area (S/A) may be calculated by S/A where Ais the area of a measurement target area and S is the surface area of the measurement target area, on the outermost surface 10A. More specifically, this may be obtained by the method illustrated in Examples described below.

Sa (arithmetic mean roughness) of the outermost surface 10A of the laminate (I) is not particularly limited but is, for example, 50 nm or more. The Sa set as 50 nm or more means that the unevenness is sufficiently formed by the wrinkle structure, and, for example, in the application to optical materials, it is possible to adjust the cloudiness. From this point of view, the Sa (arithmetic mean roughness) is preferably 100 nm or more, more preferably 200 nm or more, further preferably 300 nm or more.

Further, the Sa (arithmetic mean roughness) is not particularly limited but is preferably 3000 nm or less, more preferably 2000 nm or less, further preferably 1800 nm or less, still further preferably 1600 nm or less, preferably 1300 nm or less above all, from the viewpoint of maintaining the physical strength of the wrinkle structure.

Sz (maximum height) of the outermost surface 10A of the laminate (I) is not particularly limited, but is preferably 4000 nm or more, more preferably 5000 nm or more, further preferably 6000 nm or more. Sz equal to or higher than these lower limit values means that sufficient buckling has progressed, and a wrinkle structure having high protrusions is formed. Therefore, for example, in the application to optical materials, it is possible to adjust the cloudiness.

The Sz (maximum height) is not particularly limited, but is preferably 20000 nm or less, more preferably 15000 nm or less, further preferably 13000 nm or less, still further preferably 10000 nm or less from the viewpoint of maintaining the physical strength of the wrinkle structure.

Sa and Sz may be measured by the method illustrated in Examples described below.

### <Base material (I)>

The base material (I) used for the laminate (I) is not particularly limited, and examples of the material include organic substances such as resins, inorganic substances such as metals or metal oxides, and organic-inorganic composites. Examples of the shape of the base material (I) include a sheet or a film, a substrate, and a three-dimensional shape product including a container or a tube. The base material (I) is preferably made of resin, and a resin film or a plastic container is more preferred. According to the manufacturing method described below, in the laminate (I), it is also possible to easily form an unevenness on a base material having a complicated shape, or the inside of a container.

### [Resin film]

The resin film used as the base material (I) is not limited in the material and configuration as long as the film has a necessary and sufficient rigidity. The resin film may have a single-layer configuration or a multi-layer configuration. When the resin film has a multi-layer configuration, the configuration may have multiple layers of four or more layers as well as two layers, or three layers as long as the effect of the present invention is not impaired.

A resin used for the resin film may be, for example, polyester, polyarylates, polyethersulfone, polycarbonate, polyetherketone, polysulfone, polyphenylenesulfide, polyester-based liquid crystal polymer, triacetylcellulose, cellulose derivative, polypropylene, polyamides, polyimide, or polycycloolefins. These resins may be used either alone or in combination of two or more thereof in the resin film.

Further, when the resin film has multiple layers, different types or the same type of resins may form the layers, respectively. Further, the resin film may have a single layer or multiple layers, in which each layer is formed with a combination of two or more of the resins.

Regardless of whether the resin film has a single-layer configuration or a multi-layer configuration, preferred is a polyester film in which a main component resin in each layer is polyester.

Here, the "main component resin" means a resin having the highest content ratio among resins forming the polyester film, and is for example, a resin whose occupation ratio is 50% by mass or more, preferably 70% by mass or more, more preferably 80% by mass or more (including 100% by mass) among resins forming the polyester film.

When polyester is contained as the main component resin, each layer of the resin film may contain a resin other than the polyester or a component other than the resin.

The polyester may be a homopolyester or a copolymerized polyester. When it is homopolyester, it is preferable obtained by polycondensation of aromatic dicarboxylic acid and aliphatic glycol. The aromatic dicarboxylic acid may be, for example, terephthalic acid or 2,6-naphthalenedicarboxylic acid. The aliphatic glycol may be, for example, ethyleneglycol, diethyleneglycol, or 1,4-cyclohexanedimethanol.

Meanwhile, the dicarboxylic acid component of the copolymerized polyester may be, for example, one or two or more of isophthalic acid, phthalic acid, terephthalic acid, 2,6-naphthalenedicarboxylic acid, and sebacic acid, and the glycol component may be, for example, one or two or more of ethyleneglycol, diethyleneglycol, propyleneglycol, butanediol, 4-cyclohexanedimethanol, and neopentylglycol.

Specific examples of the polyester include, for example, polyethyleneterephthalate (PET), polyethylenenaphthalate (PEN), polybutyleneterephthalate (PBT), and polybutylenenaphthalate (PBN). Among these, PET and PEN are preferable, and PET is more preferable.

The resin film may contain particles for the purpose of forming a fine unevenness structure on the film surface to impart various functions and for the main purpose of preventing occurrence of scratches in each step.

The type of the particles is not particularly limited as long as the particles may impart ease of slipperiness. Examples thereof include inorganic particles such as silica, calcium carbonate, magnesium carbonate, barium carbonate, calcium sulfate, calcium phosphate, magnesium phosphate, kaolin, aluminum oxide, and titanium oxide and organic particles such as acrylic resin, styrene resin, urea resin, phenol resin, epoxy resin, and benzoguanamine resin. These may be used alone, or among these, two or more thereof may be used in combination. Further, in the step of producing a resin component such as polyester, precipitated particles obtained by precipitating and finely dispersing a part of a metal compound such as a catalyst may also be used.

The shape of the particles is not particularly limited. For example, it may be any of a spherical shape, a lumpy shape, a rod shape, and a flat shape. Further, there are also no particular limitations on the hardness, specific gravity, color, etc. of the particles. As this series of particles, if necessary, two or more types may be used in combination.

The average particle size of the particles is preferably 5 µm or less, more preferably 0.01 µm or more and 3 µm or less, further preferably 0.5 µm or more and 2.5 µm or less. When it is set as 5 µm or less, in the surface roughness of the resin film, roughing is prevented, and thus problems hardly occur when the resin layer (I), and the cover layer (I) are formed.

The content of the particles is preferably 5% by mass or less, more preferably 0.0003% by mass or more and 3% by mass or less, further preferably 0.01% by mass or more and 2% by mass or less relative to 100% by mass of the resin film. When the content of the particles is set in this range, it is possible to achieve both the slipperiness and transparency of the film.

The method of adding the particles to the resin film is not particularly limited, and a conventionally known method may be adopted. For example, addition may be performed in the process of producing the resin component. For example, in the case of the polyester film, the addition may be performed at any stage in the production of polyester. It is preferable to perform addition after an esterification or transesterification reaction is completed.

If necessary, a conventionally known antioxidant, an antistatic agent, a heat stabilizer, a lubricant, a dye, a pigment, a UV absorber, or the like may be added to the resin film.

The thickness of the resin film is not particularly limited as long as it falls in a range where formation into a film is possible, but is preferably 12 µm or more and 250 µm or less, more preferably 25 µm or more and 250 µm or less, further preferably 50 µm or more and 200 µm or less.

The resin film may be formed by forming, for example, a resin composition into a film shape through a melting film-forming method or a solution film-forming method. In the case of a multi-layer structure, co-extrusion may be performed. Further, it may be uniaxially stretched or biaxially stretched, and a biaxially stretched film is preferable in terms of rigidity.

### [Plastic container]

The plastic container used as the base material (I) is not particularly limited, and may be a bottomed cylindrical container, or a round-bottomed container having an elliptical cross section. Further, it may be a container having a substantially rectangular cross section in which the mouth is reduced in the diameter with respect to the body. The caliber of the container may be reduced in the diameter.

Examples of a plastic material forming the plastic container include polyethylene terephthalate resin (PET), polyethylene terephthalate-based copolymer resin (a copolymer resin or the like, in which instead of ethylene glycol, cyclohexanedimethanol or the other is used as a comonomer in an alcohol component of polyester), polybutylene terephthalate resin, polyethylene naphthalate resin, polyethylene resin, polypropylene resin (PP), cycloolefin copolymer resin (COC, cyclic olefin copolymer), ionomer resin, poly-4-methylpentene-1 resin, polymethyl methacrylate resin, polystyrene resin, ethylene-vinyl alcohol copolymer resin, acrylonitrile resin, polyvinyl chloride resin, polyvinylidene chloride resin, polyamide resin, polyamideimide resin, polyacetal resin, polycarbonate resin (PC), polysulfone resin, ethylene tetrafluoride resin, acrylonitrile-styrene resin, and acrylonitrile-butadiene-styrene resin. Among these, in terms of versatility, polyethyleneterephthalate resin (PET) or polycarbonate resin (PC) is preferable.

### [Base material other than resin]

A base material other than the resin is not particularly limited as long as the resin layer (I) described below may be fixed on the base material (I), but examples thereof include metals, semi-metals, ceramics, and composite materials.

Examples of the metal include aluminum, copper, silver, gold, iron, and nickel, and these metals may be used alone or as an alloy. Preferred examples thereof include aluminum, copper, and a steel-based material such as SUS.

Examples of the semi-metal include silicon, and germanium, and these semi-metals may be used alone or as an alloy.

Examples of the ceramics include inorganic solid materials such as oxides, carbides, nitrides, and borides, and preferred examples thereof include glass and ceramics.

The composite material is a material in which two or more types of different materials selected from resin, metal, semi-metal, ceramic, and the like are integrally combined, and examples thereof include glass fiber reinforced plastic, carbon fiber reinforced plastic, and nanocomposite material.

As these base materials other than the resin, a metal container, a glass container, and the like are suitable.

### <Resin layer (I)>

The resin layer (I) is formed by a heat- or active energy ray-curable resin composition (hereinafter, also simply referred to as a "curable resin composition"). The resin layer (I) is a cured product formed by curing the curable resin composition. Through curing, the curable resin composition may easily adhere to the base material (I), the cover layer (I), or the like. Further, when subjected to surface-treatment through a dry process in a semi-cured state or the like as described below, the resin layer (I) may buckle and form a wrinkle structure while following the compressive stress applied along the plane direction.

### [Thermosetting resin composition]

When the curable resin composition is a thermosetting resin composition, the thermosetting resin composition preferably contains a binder resin, more preferably contains a binder resin and a curing agent. By containing the binder resin and the curing agent, the thermosetting resin composition easily buckles according to the application of the compressive stress while adhesiveness to the base material (I), the cover layer (I) and the like is secured, and therefore, it is easy to form a wrinkle structure.

### (Binder resin)

The binder resin is a thermosetting resin that can be cured through heating, and is a resin cured in the presence of the curing agent when the thermosetting resin composition contains the curing agent.

Examples of the binder resin include polyester resin, urethane resin, acrylic resin, vinyl alcohol resin, ethylenevinyl alcohol resin, vinyl modified resin, oxazoline group-containing resin, carbodiimide group-containing resin, epoxy group-containing resin, isocyanate group-containing resin, alkoxy group-containing resin, modified styrene resin and modified silicon resin. These may be used alone or in combination of two or more thereof. In the binder resin, binder resins may be reacted with each other to form the resin layer (I).

Among these, in terms of the adhesion to the base material (I) or the base material (I) and the cover layer (I), and the hot-water resistance, it is preferable to use at least one selected from polyester resin, urethane resin, acrylic resin, epoxy group-containing resin, and alkoxy group-containing resin alone or a combination of two or more thereof, and acrylic resin is more preferable.

Further, the binder resin may be any resin that is capable of thermally crosslinking such as urethane curing or epoxy curing, and is preferably polyol having two or more hydroxy groups in one molecule from the viewpoint of reactivity with an isocyanate compound used as the curing agent described below. Above all, acrylpolyol is preferable.

Examples of the acrylic resin include (meth)acrylic polymers obtained by polymerizing polymerizable monomers containing (meth)acrylic monomers. The (meth)acrylic polymer may be a homopolymer or a copolymer, or further may be any one of copolymer with a polymerizable monomer other than the (meth)acrylic monomer.

The (meth)acrylic monomer is a monomer having a (meth)acryloyl group. Further, the polymerizable monomer other than the (meth)acrylic monomer is a monomer having a polymerizable functional group. Examples of the polymerizable functional group include a functional group having a carbon-carbon unsaturated bond such as a vinyl group other than the (meth)acryloyl group.

In this specification, when the expression of the (meth)acryloyl group is used, this means either or both of an "acryloyl group" and a "methacryloyl group".

The same also applies to other similar terms.

As the polymerizable monomer, hydrocarbon-based (meth)acrylate in which a portion other than a polymerizable functional group is composed of hydrocarbon is exemplified, including alkyl(meth)acrylates such as methyl(meth)acrylate, ethyl(meth)acrylate, n-propyl(meth)acrylate, isopropyl(meth)acrylate, n-butyl(meth)acrylate, isobutyl(meth)acrylate, sec-butyl(meth)acrylate, tert-butyl(meth)acrylate, amyl(meth)acrylate, isoamyl(meth)acrylate, n-hexyl(meth)acrylate, 2-ethylhexyl(meth)acrylate, pentadecyl(meth)acrylate, and dodecyl(meth)acrylate; cyclic alkyl(meth)acrylates such as cyclohexyl(meth)acrylate, and isobornyl(meth)acrylate; and (meth)acrylate having an aromatic ring such as phenyl(meth)acrylate.

Among these, alkyl(meth)acrylate or cyclic alkyl(meth)acrylate is preferable, methyl(meth)acrylate, ethyl(meth)acrylate, isopropyl(meth)acrylate, n-butyl(meth)acrylate, isobutyl(meth)acrylate, 2-ethylhexyl(meth)acrylate, and cyclohexyl(meth)acrylate are more preferable, and methyl(meth)acrylate, n-butyl(meth)acrylate, isobutyl(meth)acrylate, 2-ethylhexyl(meth)acrylate, and cyclohexyl(meth)acrylate are further preferable.

In the (meth)acrylic polymer, the structural unit derived from the hydrocarbon-based (meth)acrylate is, for example, 20% by mass or more and 90% by mass or less, preferably 30% by mass or more and 80% by mass or less.

As the polymerizable monomer, a monomer component other than hydrocarbon-based (meth)acrylate may be used, and specifically, it is preferable to use a hydroxy group-containing monomer. Examples of the hydroxy group-containing monomer include hydroxyalkyl(meth)acrylates such as 2-hydroxyethyl(meth)acrylate, 2-hydroxypropyl(meth)acrylate, 2-hydroxybutyl(meth)acrylate, 4-hydroxybutyl(meth)acrylate, and 6-hydroxyhexyl(meth)acrylate. A hydroxy group referred to in the hydroxy group-containing monomer is a hydroxy group that is not directly bonded to an aromatic ring. Among these, 2-hydroxyethyl(meth)acrylate, 2-hydroxypropyl(meth)acrylate, and 2-hydroxybutyl(meth)acrylate are preferable.

The hydroxy group-containing monomer is preferably used in combination with the hydrocarbon-based (meth)acrylate. Thus, the acrylic resin is preferably a (meth)acrylic copolymer obtained by copolymerizing the hydrocarbon-based (meth)acrylate and the hydroxy group-containing monomer, or a (meth)acrylic copolymer obtained by copolymerizing the hydrocarbon-based (meth)acrylate, the hydroxy group-containing monomer, and a monomer component other than these (another monomer component). Accordingly, the (meth)acrylic copolymer may be acrylpolyol containing a plurality of hydroxy groups.

In the (meth)acrylic polymer, the structural unit derived from the hydroxy group-containing monomer is preferably, for example, 0.5% by mass or more and 80% by mass or less, more preferably 1% by mass or more and 70% by mass or less.

As the polymerizable monomer, a monomer component (another monomer component) other than the hydrocarbon-based (meth)acrylate and the hydroxy group-containing monomer may be used. Specific examples thereof include: carboxy group-containing monomers such as acrylic acid, methacrylic acid, crotonic acid, itaconic acid, fumaric acid, maleic acid, and citraconic acid; amino group-containing monomers such as dimethylaminoethyl(meth)acrylate, dimethylaminoethyl(meth)methacrylate, and diethylaminoethyl(meth)acrylate; epoxy group-containing monomers such as glycidyl(meth)acrylate, β-methylglycidyl(meth)acrylate, o-vinylbenzylglycidylether, m-vinylbenzylglycidylether, p -vinylbenzylglycidylether, α-methyl-o-vinylbenzylglycidylether, α-methyl-m-vinylbenzylglycidylether, α-methyl-p-vinylbenzylglycidylether, and 3,4-epoxycyclohexylmethyl(meth)acrylate; alkyleneglycolmonoalkylether(meth)acrylate such as ethyleneglycolmonomethyletheracrylate, and ethyleneglycolmonomethylethermethacrylate; acrylamide-based compounds such as (meth)acrylamides, diacetoneacrylamide, and N-methylolacrylamide; (meth)acrylonitrile; styrene derivatives such as styrene, α-methylstyrene, divinylbenzene, and vinyltoluene; and various vinyl halides such as vinyl chloride, and vinylidene chloride.

Further, as the polymerizable monomer, a monomer having a functional group having an UV absorbing function may be used from the viewpoint of improving the light resistance or the like of the resin layer (I). Specific examples thereof include monomers having a UV absorbing functional group such as a benzotriazole skeleton, a benzophenone skeleton, a triazine skeleton, and a hindered amine skeleton, and a polymerizable functional group such as a (meth)acryloyl group.

The content of the structural unit derived from another monomer component (a monomer component other than the hydrocarbon-based (meth)acrylate and the hydroxy group-containing monomer) is, for example, 50% by mass or less, preferably 40% by mass or less in the (meth)acrylic polymer. It is 0% by mass or more but its lower limit is not particularly limited.

Each of the monomer components (the hydrocarbon-based (meth)acrylate, the hydroxy group-containing monomer, and another monomer component) is preferably a monofunctional monomer having one polymerizable functional group in the molecule, as exemplified above. However, as long as the effect of the present invention is not impaired, a polyfunctional monomer having two or more polymerizable functional groups may be appropriately contained.

### (Curing Agent)

As the curing agent, a compound that can react with the binder resin for curing may be used. From the viewpoint of curability with the binder resin, an isocyanate compound is preferably used. When the isocyanate compound is used, the binder resin may have a functional group capable of reacting with an isocyanate group. Examples of the functional group include a hydroxy group, a carboxy group, and an amino group, and from the viewpoint of reactivity with the isocyanate group, a hydroxy group is preferable.

Therefore, it is preferable to use the isocyanate compound as the curing agent, and polyol as the binder resin. When the acrylic resin is used, the acrylic resin is preferably acrylpolyol containing a plurality of hydroxy groups in one molecule as described above.

The isocyanate compound is preferably aromatic or aliphatic diisocyanate or trivalent or higher polyisocyanate. As the isocyanate compound, for example, tetramethylenediisocyanate, hexamethylenediisocyanate, toluenediisocyanate, diphenylmethanediisocyanate, hydrogenated diphenylmethanediisocyanate, xylenediisocyanate, hydrogenated xylenediisocyanate, isophoronediisocyanate, cyclohexanediisocyanate, dicyclohexyldiisocyanate, or a trimer thereof may be used.

Further, a terminal-isocyanate group-containing compound may be used, which is obtained by reacting an excess amount of these isocyanate compounds with, for example, a low molecular weight active hydrogen compound such as ethyleneglycol, propyleneglycol, trimethylolpropane, glycerin, sorbitol, biuret, cyanuric acid, ethylenediamine, monoethanolamine, diethanolamine and triethanolamine, or a polymeric active hydrogen compound such as polyesterpolyol, polyetherpolyol and polyamide.

### (Blending ratio of each component)

In the thermosetting resin composition, a ratio of the number of hydroxy groups of the binder resin to the number of isocyanate groups of the curing agent, as the blending ratio of the binder resin to the curing agent in the mixing, may be adjusted, and (the number of isocyanate groups )/(the number of hydroxy groups ) is preferably 0.05 or more and 30 or less, more preferably 0.1 or more and 20 or less, further preferably 0.2 or more and 15 or less.

### (Preferable mode of thermosetting resin composition)

When the resin layer (I) is formed of the thermosetting resin composition, it is preferable that the resin layer (I) contains a resin having a urethane bond. When the resin having the urethane bond is used, the flexibility is secured, and thus buckling is easily generated by the compressive stress occurring when a surface treatment is carried out by a dry process.

The urethane bond is preferably formed by at least one of a reaction between the binder resins, and a reaction between the binder resin and the curing agent, and above these, formation by the reaction between the binder resin and the curing agent is more preferable. When the urethane bond is formed by such a reaction, it becomes easy to improve the adhesion of the resin layer (I) to the cover layer (I), the base material (I), and the like.

Further, from the viewpoint of promotion of curability with the binder resin and the adhesion, it is preferable to use the isocyanate compound as the curing agent.

### [Active energy ray-curable resin composition]

### (Photopolymerizable compound)

When the curable resin composition is an active energy ray-curable resin composition, the active energy ray-curable resin composition contains a photopolymerizable compound. The photopolymerizable compound is a compound that may be polymerized by being irradiated with active energy rays. Further, details of the active energy rays are as described in the manufacturing method described below.

As the resin component of the resin layer (I) formed by the active energy ray-curable resin composition, a mixture of a prepolymer such as epoxy(meth)acrylate, urethane(meth)acrylate, polyester(meth)acrylate, or acryl(meth)acrylate, with a photopolymerizable monomer, or only a photopolymerizable monomer may be used.

The photopolymerizable monomer is not particularly limited as long as it is a compound having a radically polymerizable group, but, for example, a polyfunctional photopolymerizable monomer may be exemplified. In the polyfunctional photopolymerizable monomer, the number of radically polymerizable groups included in one molecule is not particularly limited, and it may be two or more.

Examples of the radically polymerizable group include a (meth)acryloyl group, and a functional group having a carbon-carbon unsaturated bond such as a vinyl group, and above all, the (meth)acryloyl group is preferable.

As the photopolymerizable monomer, polyfunctional (meth)acrylate having an aromatic ring is exemplified, and specifically, polyfunctional (meth)acrylates having a benzene ring, a naphthalene ring, an anthracene ring, a fluorene ring, a phenanthrene ring, a phenalene ring, or the like are preferable. Among these, fluorene-based polyfunctional (meth)acrylate having a fluorene ring is preferable.

Examples of the fluorene-based polyfunctional (meth)acrylate include 9,9-bis[4-(2-(meth)acryloyloxyethoxy)phenyl]fluorene, 9,9-bis[4-(2-(meth)acryloyloxyethoxy)-3-methylphenyl]fluorene, 9,9-bis[4-(2-(meth)acryloyloxypropoxy)-3-methylphenyl]fluorene, 9,9-bis[4-(2-(meth)acryloyloxyethoxy)-3,5-dimethylphenyl]fluorene, 9,9-bis[4-((meth)acryloyloxypoly(ethyleneoxy))phenyl]fluorene, 9,9-bis[4-((meth)acryloyloxypolyethyleneoxy)-3-methylphenyl]fluorene, 9,9-bis[4-((meth)acryloyloxypoly(propyleneoxy))-3-methylphenyl]fluorene, and 9,9-bis[4-((meth)acryloyloxypoly(ethyleneoxy))-3,5-dimethylphenyl]fluorene.

Further, as the photopolymerizable monomer, besides the polyfunctional (meth)acrylate having the aromatic ring, various polyfunctional (meth)acrylates may be used, and examples thereof include aliphatic polyfunctional (meth)acrylates such as ethyleneglycoldi(meth)acrylate, polyethyleneglycoldi(meth)acrylate, propyleneglycoldi(meth)acrylate, polypropyleneglycoldi(meth)acrylate, butanedioldi(meth)acrylate, hexanedioldi(meth)acrylate, nonanedioldi(meth)acrylate, trimethylolpropanetri(meth)acrylate, and tricyclodecanedimethanoldi(meth)acrylate.

The above-described photopolymerizable monomer may be used alone or in combination of two or more thereof.

Among the above, the polyfunctional (meth)acrylate having the aromatic ring is preferable, and the polyfunctional (meth)acrylate having the aromatic ring may be used in combination with another photopolymerizable compound.

The photopolymerizable monomer may be used alone, or may be used in combination with a monofunctional photopolymerizable compound described below.

The photopolymerizable monomer is not limited to polyfunctional ones, and may be a monofunctional photopolymerizable monomer. The monofunctional photopolymerizable monomer may be used alone, but may be used in combination with the polyfunctional photopolymerizable monomer as described above.

Examples of the monofunctional photopolymerizable monomer include alkyl(meth)acrylate, cyclic alkyl(meth)acrylate, (meth)acrylate having an aromatic ring, a hydroxy group-containing monomer, a carboxy group-containing monomer, an amino group-containing monomer, an epoxy group-containing monomer, an acrylamide-based compound, (meth)acrylonitrile, a styrene derivative, and vinyl halide. As these specific compounds, those exemplified in the above-described (meth)acrylic polymer may be appropriately used.

### (Photopolymerization initiator)

When the curable resin composition contains the photopolymerizable compound, it is preferable to further contain a photopolymerization initiator. In the case where the photopolymerization initiator is contained, the resin layer (I) precursor can be easily cured by irradiating a resin layer (I) precursor with active energy rays.

Examples of the photopolymerization initiator include benzyl, benzophenone or derivatives thereof, thioxanthones, benzyldimethylketals, α-hydroxyalkylphenones, α-hydroxyacetophenones, hydroxyketones, aminoalkylphenones, acylphosphineoxides, and oxime ester compounds. Among these, α-hydroxyalkylphenones are preferable because they hardly cause yellowing during curing, and thus a transparent cured product may be obtained.

The content of the photopolymerization initiator is preferably in a range of 0.05 parts by mass or more and 5 parts by mass or less relative to 100 parts by mass of the curable resin composition, further preferably in a range of 0.2 parts by mass or more and 3 parts by mass or less. When the content of the photopolymerization initiator is 0.05 parts by mass or more, a desired initiation effect is obtained, and also when the content of the photo initiator is 5 parts by mass or less, during irradiation of the active energy rays, the curable resin composition is likely to remain in a semi-cured state without being over-cured.

In the above description, descriptions have been made on a mode where the curable resin composition is either heat-curable or active energy ray-curable, but the curable resin composition may be heat- and active energy ray-curable, which can be cured by both heat and active energy rays. In this case, the curable resin composition may contain both the binder resin and the photopolymerizable compound.

If necessary, in a range where the gist of the present invention is not impaired, the curable resin composition may contain an internal defoaming agent, an applicability improver, a thickener, an organic lubricant, a UV absorber, an antioxidant, a foaming agent, a dye, a pigment, inorganic particles, organic particles, and the like. These additives may be used alone, and if necessary, two or more thereof may be used in combination.

### [Thickness of resin layer (I)]

The thickness (tb) of the resin layer (I) may be adjusted according to a level difference in an unevenness to be formed or the application, and is not limited, but is preferably 0.1 µm or more and 15 µm or less. When it is 15 µm or less, it can prevent peeling from the base material (I) due to the internal stress of the resin layer (I) itself. When the thickness is 0.1 µm or more, the thickness of the resin layer (I) may be kept uniform, and thus by a wrinkle structure, the roughness of a certain level or higher may be secured. From this point of view, the thickness (tb) of the resin layer (I) is more preferably 0.5 µm or more, further preferably 1 µm or more, still further preferably 2 µm or more, and also is preferably 10 µm or less, more preferably 7 µm or less.

The thicknesses of the resin layer (I), and the cover layer (I) and the over cover layer (I) described below can be obtained by measuring level differences by using a fine shape measuring machine, or measuring the maximum thickness (a convex mountain portion) and the minimum thickness (a concave valley portion) through cross-sectional observation using a scanning electron microscope (SEM) and/or a transmission electron microscope (TEM), and then obtaining an average value of these.

### <Cover layer (I)>

In the present invention, as described above, it is preferable to form the cover layer (I) on the resin layer (I). The cover layer (I) may be formed as a layer that is in direct contact with the top of the resin layer (I). The cover layer (I) may be, specifically, an inorganic substance-containing layer or a cover resin layer or the like. Among these, the inorganic substance-containing layer is preferable.

In the following description, for distinguishing from an inorganic substance-containing layer constituting the over cover layer (I) described below, the inorganic substance-containing layer constituting the cover layer (I) may be referred to as an inorganic substance-containing layer (1).

### [Inorganic substance-containing layer (1)]

The inorganic substance-containing layer (1) is a layer formed of an inorganic substance, and containing the inorganic substance as a main component. Containing the inorganic substance as the main component means that the inorganic substance accounts for 50% by mass or more, particularly 70% by mass or more, particularly 80% by mass or more, particularly 90% by mass or more, particularly 100% by mass of the inorganic substance-containing layer. The inorganic substance-containing layer (1) may be formed of an inorganic substance having good adhesion to the resin layer (I). Further, it is preferable that the inorganic substance-containing layer (1) is formed by using a material that can be easily formed in film on the resin layer (I) through a dry process.

The inorganic substance-containing layer (1) is preferably formed of the inorganic substance that is at least one selected from diamond-like carbon (DLC), metal, metal oxide, metal nitride, metal carbide, or composites thereof. The metal referred to herein also includes so-called semi-metals such as silicon, boron, and germanium.

In the inorganic substance-containing layer (1), examples of the metal constituting metal, metal oxide, metal nitride, metal carbide, or composites thereof include silicon, aluminum, zinc, titanium, niobium, gold, silver, copper, indium, tin, and nickel, and among these, silicon, and niobium are preferable, and silicon is more preferable.

The inorganic substance used for the inorganic substance-containing layer (1) is preferably at least one selected from silicon-based compounds such as silicon oxide, silicon nitride, silicon oxide/nitride, silicon oxide/carbide, silicon oxide/carbide/nitride, silicon carbide, fluorine-containing silicon oxide, and fluorine-containing silicon carbide, aluminum-based compounds such as aluminum oxide, aluminum nitride, aluminum oxide/nitride, and aluminum oxide/carbide, niobium-based compounds such as niobium oxide, zinc-based compounds such as zinc oxide, titanium-based compounds such as titanium oxide, diamond-like carbon, fluorine-containing diamond-like carbon, and conductive oxides such as ITO and IZO.

From the viewpoint that the hardness of the laminate (I) may be increased, and thus the durability of the laminate (I) may be improved, among the above, the inorganic substance-containing layer (1) is preferably a layer containing at least one of diamond-like carbon (DLC), silicon oxide, niobium oxide, silicon oxide/carbide, and silicon carbide, as the inorganic substance, more preferably a layer containing at least one of DLC, silicon oxide, and niobium oxide. Among these, as the inorganic substance-containing layer, a DLC layer formed of diamond-like carbon (DLC) is more preferable. When DLC is used, the film stress occurring during the formation of the inorganic substance-containing layer (1) tends to be increased, and then the above-described higher-order wrinkle structure is easily formed.

### [Cover resin layer]

The cover resin layer is preferably formed on the resin layer (I) by a dry process described below. The cover resin layer is a layer formed of a resin component and containing the resin component as a main component. Here, containing the resin component as the main component means that the resin component accounts for 50% by mass or more, particularly 70% by mass or more, particularly 80% by mass or more, particularly 90% by mass or more, particularly 100% by mass of the cover resin layer.

As the resin component used for the cover resin layer, a resin component that can be formed in film on the resin layer (I) through a dry process can be preferably used. Specific examples of the resin component include fluorine-based resin, polyethylene, and polystyrene, and above all, a fluorine-based resin layer formed of a fluorine-based resin is preferable. By using the fluorine-based resin, it is possible to easily form the cover resin layer on the resin layer (I) through a dry process. Further, when the cover resin layer becomes the outermost surface, by using the fluorine-based resin, it becomes easy to impart chemical resistance, slipperiness or liquid repellency to the laminate (I).

Examples of the fluorine-based resin include polytetrafluoroethylene and tetrafluoroethylene-ethylene copolymer.

### [Formation of cover layer (I)]

The cover layer (I) is preferably formed by a dry process as described below, but does not necessarily need to be formed through the dry process. When the cover layer (I) is not formed through the dry process, as illustrated in Example 13, an unevenness containing a wrinkle structure may be formed on the resin layer (I) in advance through a different dry process, and then the cover layer (I) may be formed.

When the cover layer (I) is formed without the dry process as described above, others than the above may also be used as the inorganic substance, and the resin component used for the inorganic substance-containing layer, and the cover resin layer. Specifically, in addition to the above-described resin components, those exemplified as the resin component that can be used for the over cover layer (I) described below may be used.

### [Thickness of cover layer (I)]

The thickness (ta) of the cover layer (I) is preferably 5 nm or more and 300 nm or less. In the case where the thickness (ta) of the cover layer (I) falls within the above range, when a film is formed through a dry process, an appropriate film stress occurs, and then a compressive stress is appropriately applied to the resin layer (I), so that it becomes easy to form a wrinkle structure with a desired roughness. From the viewpoint of facilitating the formation of a desired unevenness on the outermost surface of the laminate (I), the thickness (ta) of the cover layer (I) is more preferably 10 nm or more and 250 nm or less, further preferably 20 nm or more and 200 nm or less.

### [Thickness ratio (ta/tb) of cover layer (I) and resin layer (I)]

In the present invention, the ratio (ta/tb) of the thickness (ta, unit: nm) of the cover layer (I) to the thickness (tb, unit: µm) of the resin layer (I) is preferably 0.1 or more and 3500 or less. In the case where the thickness ratio falls within the above range, when the cover layer (I) is formed through a dry process, it becomes easy to form an unevenness of a wrinkle structure with a desired roughness through the dry process. Further, when the unevenness containing the wrinkle structure is formed on the surface of the resin layer (I) in advance before the cover layer (I) is formed, the smoothing of the unevenness by the cover layer (I) may be prevented.

From the viewpoint of facilitating the formation of a desired unevenness on the outermost surface of the laminate (I), the thickness ratio is more preferably 1 or more and 500 or less, further preferably 2 or more and 400 or less, still further preferably 5 or more and 250 or less.

### <Over cover layer (I)>

The over cover layer (I) is a layer further provided on the cover layer (I). The over cover layer (I) may be, for example, an inorganic substance-containing layer or an over cover resin layer. In the over cover layer (I), by appropriately changing materials, it is possible to impart various functions to the outermost surface of the laminate (I). The over cover layer (I) may be composed of one single layer, or two or more layers may be laminated. When the over cover layer (I) is provided as two or more layers, for example, it may be a combination of one or more inorganic substance-containing layers and one or more over cover resin layers.

In the following description, for distinguishing from the inorganic substance-containing layer (1) constituting the above-described cover layer (I), the inorganic substance-containing layer constituting the over cover layer (I) may be referred to as an inorganic substance-containing layer (2).

### [Inorganic substance-containing layer (2)]

The inorganic substance-containing layer (2) is a layer formed of an inorganic substance, and containing the inorganic substance as a main component. When the cover layer (I) is the inorganic substance-containing layer (1), the inorganic substance-containing layer (2) may have a different composition from the inorganic substance-containing layer (1), and may contain an inorganic substance different from the inorganic substance contained in the inorganic substance-containing layer (1), for example.

The inorganic substance-containing layer (2) may be formed of an inorganic substance having good adhesion to the cover layer (I). Further, a material for the inorganic substance-containing layer (2) may be a material that can be formed in film on the cover layer (I) through a dry process, or can be formed in film on the cover layer (I) through a method other than the dry process.

It is preferable that the inorganic substance-containing layer (2) is formed of a thin film containing the inorganic substance that is at least one selected from diamond-like carbon (DLC), metal, metal oxide, metal nitride, metal carbide, or composites thereof.

In the inorganic substance-containing layer (2), examples of the metal constituting metal, metal oxide, metal nitride, metal carbide, or composites thereof include silicon, aluminum, zinc, titanium, niobium, gold, silver, copper, indium, tin, and nickel, and among these, silicon and niobium are preferable, and silicon is more preferable.

The inorganic substance used for the inorganic substance-containing layer (2) is preferably at least one selected from silicon-based compounds such as silicon oxide, silicon nitride, silicon oxide/nitride, silicon oxide/carbide, silicon oxide/carbide/nitride, silicon carbide, fluorine-containing silicon oxide, and fluorine-containing silicon carbide, aluminum-based compounds such as aluminum oxide, aluminum nitride, aluminum oxide/nitride, and aluminum oxide/carbide, niobium-based compounds such as niobium oxide, zinc-based compounds such as zinc oxide, titanium-based compounds such as titanium oxide, diamond-like carbon, fluorine-containing diamond-like carbon, and conductive oxides such as ITO and IZO.

Among the above, the inorganic substance-containing layer (2) is preferably a layer containing silicon carbide as the inorganic substance. That is, the inorganic substance-containing layer is preferably a silicon carbide layer using silicon carbide as the inorganic substance. When silicon carbide is used, it is possible to increase the hardness of the outermost surface of the laminate (I) and to improve the heat resistance, the durability, and the like of the laminate (I).

### [Over cover resin layer]

The over cover resin layer is a layer formed of a resin component, and containing the resin component as a main component. When the cover layer (I) is the cover resin layer, the over cover resin layer may have a different composition from the cover layer (I), and may contain a resin component different from the resin component contained in the cover resin layer, for example.

The resin component that may be used for the over cover resin layer is not particularly limited as long as it can adhere to the cover layer, and examples thereof include fluorine-based resin, silicon resin, acrylic resin, and epoxy resin.

Among the above, a fluorine-based resin layer using a fluorine-based resin is preferable. By using the fluororesin layer, it becomes easy to impart chemical resistance, slipperiness or liquid repellency to the laminate (I). Further, specific compounds for the fluorine-based resin are the same as described in the cover layer (I). By using these resins, it is possible to form the over cover resin layer through a dry process.

### [Thickness of over cover layer (I)]

The thickness of the over cover layer (I) is not particularly limited as long as the unevenness of the wrinkle structure formed by the resin layer (I) appears on the outermost surface, but is preferably 5 nm or more and 300 nm or less, more preferably 10 nm or more and 250 nm or less, further preferably 20 nm or more and 200 nm or less.

### <Manufacturing method of laminate (I)>

The laminate (I) may be manufactured by any manufacturing method, but the manufacturing method of the laminate (I) according to an example of the present embodiment includes the following steps 1 to 3.
Step 1: a step of applying a curable resin composition on at least one surface of the base material (I) to form a resin layer (I) precursor
Step 2: a step of semi-curing the resin layer (I) precursor formed in step 1
Step 3: a step of further performing a surface treatment through a dry process to the resin layer (I) precursor semi-cured in step 2, so as to form an unevenness containing a wrinkle structure on the surface on the one surface side of the base material (I).

Meanwhile, step 2 may be omitted as described below. Therefore, in step 3, the surface treatment may be carried out to the uncured resin layer (I) precursor.

Hereinafter, each step will be described in more detail.

### [Step 1]

In step 1, the curable resin composition is applied on at least one surface of the base material (I) to form the resin layer (I) precursor.

Details of the curable resin composition used in step 1 are the same as described above. If necessary, the curable resin composition may be diluted with a solvent such as water or an organic solvent. In the case of dilution with a solvent such as water or an organic solvent, the above-described amount (parts by mass, etc.) of the curable resin composition and the amount of each component constituting the composition mean those based on the solid content.

The organic solvent to be used is not particularly limited, and may be selected from the viewpoint of solubility or dispersibility according to the composition of the curable resin composition. Examples thereof include: alcohol based-solvents such as methyl alcohol, ethyl alcohol, and isopropyl alcohol, ether based-solvents such as dimethyl glycol, and ethyleneglycol monoethylether, ester based-solvents such as ethyl acetate, acetate based-solvents such as propyleneglycol monomethylether acetate, ketone based-solvents such as methylisobutylketone, and methylethylketone, aliphatic hydrocarbon-based solvents such as various alkanes, and aromatic hydrocarbon-based solvents such as toluene, xylene, and benzene.

As for the organic solvent, only one type or two or more types may be appropriately used. Components constituting the curable resin composition may be dissolved in the solvent or may be dispersed in the solvent.

When the curable resin composition is diluted with water, an organic solvent, or the like, it is preferable to adjust the solid content concentration to, for example, about 0.1% by mass or more and 50% by mass or less, preferably 3% by mass or more and 40% by mass or less.

As a method of applying the curable resin composition on the base material (I), it is possible to use conventionally known coating methods such as reverse gravure coating, direct gravure coating, roll coating, die coating, bar coating, curtain coating, spray coating, dip coating, and spin coating.

Further, when the base material (I) is a resin film, the curable resin composition may be applied through in-line coating. The in-line coating refers to applying the curable resin composition on a production line on which the resin film is formed.

In the drying of the solvent after coating, heat-drying by an oven or unheated-drying by a vacuum dryer may be utilized.

The surface of the base material (I) to which the curable resin composition is applied may be subjected in advance to a surface treatment such as corona treatment, plasma treatment, or UV ozone treatment.

### [Step 2]

In step 2, the curable resin composition in the resin layer (I) precursor formed in step 1 is put into the semi-cured state. Semi-curing referred to herein refers to a state where the curable resin composition is not completely cured, and refers to a state where the curing of the curable resin composition further progresses through further irradiation of heat or irradiation of energy rays.

Whether the curable resin composition is semi-cured may be determined by whether the surface of the base material (I) is exposed after the surface of the resin layer (I) precursor is lightly rubbed 50 times with a cotton swab soaked in a solvent, for example. If the curable resin composition is completely cured, the surface of the base material (I) is not exposed even when the surface of the resin layer (I) precursor is rubbed. The degree of semi-curing may be determined from the number of times of rubbing when the film reduction is started on the surface of the resin layer (I) precursor or the number of times of rubbing until the surface of the base material (I) is exposed. As the solvent in which the cotton swab is soaked, the same as the solvent for dilution of the curable resin composition is preferably used.

The purpose of semi-curing is to make the resin layer (I) precursor obtained in step 1 have properties advantageous in handling before the loading into the vacuum dry process of step 3 and to control the wrinkle structure to be formed in step 3.

Therefore, for example, when the resin layer (I) precursor obtained in step 1 has a strong tuck and is difficult to handle, it is preferable to perform a semi-curing treatment, but if there is no problem in handling, this step 2 is not necessary and heating or energy ray irradiation may not be performed.

Further, when the curable resin composition is put into the semi-cured state, buckling of the resin layer (I) precursor easily occurs by the surface treatment through the dry process in step 3, and it becomes easy to form the unevenness containing the wrinkle structure.

When the curable resin composition has a thermosetting property, in this step 2, the resin layer (I) precursor formed in step 1 is semi-cured by heating. The method of semi-curing the resin layer (I) precursor may be carried out at room temperature as in natural drying or the like but is preferably carried out through heating as in heat-drying or the like from the viewpoint of practical use. When the drying of the solvent in step 1 is performed through heat-drying, the drying for the solvent may also serve as this step 2.

Further, when the curable resin composition has an active energy ray curability, in this step 2, the resin layer (I) precursor formed in step 1 is irradiated with active energy rays so that the resin layer (I) precursor is semi-cured. Meanwhile, when a heat- and active energy ray-curable resin composition is used as the resin layer (I) component, the resin layer (I) precursor may be semi-cured through only heating or only active energy ray irradiation, or the resin layer (I) precursor may be semi-cured by using a combination of heating and active energy irradiation.

When the resin layer (I) precursor is semi-cured by heating, the heating temperature and the heating time may be set according to components contained in the curable resin composition. The resin layer (I) precursor is heated at a temperature of, for example, 50°C or more and 200°C or less, preferably 70°C or more and 150°C or less, for a time of, for example, 3 sec or more and 30 min or less, preferably 30 sec or more and 10 min or less, more preferably 40 sec or more and 5 min or less.

Further, when the resin layer (I) precursor is semi-cured by being irradiated with active energy rays, as active energy rays to be used, it is possible to use electron beams, proton beams, neutron beams, and the like as well as rays such as far UV rays, UV rays, near UV rays, and infrared rays, and electromagnetic waves such as X-rays, and γ-rays. Curing by UV ray irradiation is advantageous in terms of the curing speed, the availability of an irradiation device, the price, and the like.

When the resin layer (I) precursor is semi-cured by being irradiated with UV rays, a high-pressure mercury lamp, a ultra-high-pressure mercury lamp, a carbon arc lamp, a metal halide lamp, a xenon lamp, a chemical lamp, a electrodeless discharge lamp, an LED lamp, and the like which emit light in the wavelength range of 150 to 450 nm may be used. Further, the irradiation amount of UV rays is not particularly limited as long as irradiation is carried out to such an extent that the resin layer (I) precursor is semi-cured, but UV ray irradiation may be carried out with a cumulative light amount of, for example, 0.5 to 5000 mJ/cm², preferably about 1 to 2000 mJ/cm².

### [Step 3]

Step 3 is a step of further performing the surface treatment through the dry process to the resin layer (I) precursor semi-cured in step 2, or the uncured resin layer (I) precursor, to form the unevenness containing the wrinkle structure on the surface on the one surface side of the base material (I). In step 3, the cover layer (I) may be formed by the dry process, but a dry process treatment that does not involve film formation may be performed without forming the cover layer (I).

Further, the wrinkle structure may have a higher-order wrinkle structure as described above, and the higher-order wrinkle structure may be formed in step 3.

The dry process is a method of performing the surface treatment to the semi-cured resin layer (I) precursor, or the uncured resin layer (I) precursor, under reduced pressure or in a vacuum.

In the present embodiment, the principle of forming the unevenness containing the wrinkle structure by the surface treatment through the dry process, and the principle of forming the higher-order wrinkle structure are not clear, but are presumed as follows.

When the cover layer (I) is formed on the semi-cured or uncured resin layer (I) precursor through the dry process, it is thought that curing of the resin layer (I) precursor progresses by energy (energy transferred from light from plasma, radiant heat, electrons or ions, or incident particles) obtained through the dry process treatment. At that time, a process in which the resin layer (I) precursor that has received energy through the dry process treatment is cured and shrunk and gets losing fluidity while the temperature rises, and a process in which a film stress is generated as the cover layer (I) grows progress at the same time. In the meantime, it is presumed that a compressive stress along the plane direction of the resin layer (I) precursor increases, and buckling occurs at a point in time when the resin layer (I) precursor cannot resist the compressive stress, and then the wrinkle structure is formed.

Further, even in the dry process that does not form the cover layer (I) and does not involve film formation, similarly, it is presumed that a compressive stress is generated along the plane direction in the resin layer (I) precursor by the energy through the dry process treatment, and buckling occurs at a point in time when the resin layer (I) precursor cannot resist the compressive stress, and then the wrinkle structure is formed.

When the cover layer (I) is formed, if the film stress occurring during the formation of the cover layer (I) is large, it is thought that first buckling occurs at an early stage so that large undulations (primary wrinkle structure) are generated, and then, second buckling occurs at a stage in which the resin fluidity is slightly decreased so that small undulations (secondary wrinkle structure) are generated.

It is presumed that the size of undulations in the wrinkle structure (that is, the surface roughness (Sa, Sz), the specific surface area S/A, the value of Ssk, etc.) changes according to the balance among the thicknesses of the resin layer (I) and the cover layer (I), the hardness of the resin layer (I) precursor in a semi-cured or uncured state, and the resin fluidity. Therefore, the size of undulations may be adjusted by appropriately changing thicknesses of the resin layer (I) and the cover layer (I), components contained in the resin layer (I) and the cover layer (I), curing conditions or the like.

Further, the surface treatment through the dry process promotes curing of the resin layer (I) precursor as described above, and may allow, for example, the resin layer (I) to be fully cured in step 3. Full curing means a state where curing does not substantially proceed even if the resin layer (I) is heated or is irradiated with active energy rays.

In this manufacturing method, it is preferable that the cover layer (I) is formed by the surface treatment through the dry process. When the cover layer (I) is formed by the surface treatment through the dry process, the film stress occurs as described above, and it becomes easy to form the wrinkle structure. Further, it is also possible to form the higher-order wrinkle structure. Further, when the cover layer (I) is formed by the surface treatment through the dry process, it is also possible to form the cover layer (I) while forming the unevenness containing the wrinkle structure in step 3. Thus, the process may be simplified.

Whether the dry process treatment has been performed may be determined by observing the cross section with an SEM and/or a TEM. For example, in the case where the cover layer (I) is made of a crystalline material, when the crystal grain size changes in the thickness direction of the cover layer (I), it can be determined that the dry process treatment has been performed. As a film formation by the dry process progresses, the crystal nuclei generated on the surface of the resin layer (I) grow, and the particle size gradually expands. Thus, the crystal grain size at the surface of the cover layer (I) becomes the largest, and the grain size of crystals nearer to the resin layer (I) tends to be decreased.

Meanwhile, when a wet treatment in which a solvent is applied is performed, such a change of the crystal grain size is not observed. In the case of the wet treatment, since the solvent evaporates in the process of drying a coating film, minute voids are likely to occur over the entire thickness direction of the cover layer (I), and then the film is likely to have a low density.

When the cover layer (I) is formed by the surface treatment through the dry process, examples of the surface treatment using the dry process include chemical vapor deposition (CVD), and physical vapor deposition (PVD).

The dry process is preferably a process performed under vacuum or reduced pressure. When the surface treatment is performed under vacuum or reduced pressure, the semi-cured or uncured resin layer (I) precursor is placed in a low oxygen atmosphere, and then the progress of curing is facilitated by the dry process. Thus, when the dry process is performed under vacuum or reduced pressure, it is easy to form the wrinkle structure. In particular, in the case of the active energy ray-curable resin composition, oxygen inhibition that hinders radical polymerization is suppressed so that crosslinking easily proceeds.

The pressure in the dry process performed under vacuum or reduced pressure depends on the method of the dry process, but is, for example, 15 Pa or less, preferably 10 Pa or less, more preferably 1 Pa or less. Further, the lower limit of the pressure in the dry process is not particularly limited but is, for example, 1×10⁻⁷ Pa in consideration of the performance limit of each device.

The CVD is not particularly limited, and includes plasma CVD, thermal CVD, cat-CVD (catalytic chemical vapor deposition method) and the like, but plasma CVD is preferable. By using plasma CVD, it becomes easy to form the wrinkle structure. The CVD is preferably performed under reduced pressure from the viewpoint of facilitating the formation of the wrinkle structure, and the pressure at the time of formation of the cover layer (I) is preferably 15 Pa or less, more preferably 1×10⁻² Pa or more and 10 Pa or less, further preferably 1×10⁻¹ Pa or more and 1 Pa or less from the viewpoint of the deposition speed and the unevenness structure forming property.

The output condition for forming the cover layer (I) is preferably 100 W or more and 1500 W or less more preferably 300 W or more and 1200 W or less, further preferably 400 W or more and 1000 W or less from the viewpoint of generating a necessary and sufficient film stress in the cover layer (I).

The adjustment of the film thickness of the cover layer (I) may be performed by a conventionally known method, and may be performed by adjusting, for example, the output, the pressure of a raw material gas, the concentration of the raw material gas, and the plasma generation time in the case where plasma CVD is used.

When the surface treatment is performed by CVD, the cover layer (I) may be subjected to a crosslinking process by electron beam irradiation, if necessary, in order to improve water resistance, and durability.

The CVD is preferably used when, for example, the inorganic substance-containing layer (1), and the cover resin layer are formed, and may be particularly suitably used when the inorganic substance-containing layer containing DLC as an inorganic substance, the inorganic substance-containing layer containing silicon carbide and/or silicon oxide as an inorganic substance, and the fluorine-based resin layer containing a fluorine-based resin as a resin component are formed.

Examples of PVD include vacuum vapor deposition, sputtering, and ion plating, and among these, vacuum vapor deposition, and sputtering are preferable. The PVD is suitable when, for example, a metal, a metal oxide such as niobium oxide or silicon oxide, or a metal nitride is used as an inorganic substance to be contained in the inorganic substance-containing layer (1).

Further, the vacuum vapor deposition is suitable when a metal such as gold, silver, copper, or aluminum, a metal oxide such as silicon oxide, titanium oxide, or aluminum oxide, or a fluoride such as calcium fluoride is used as an inorganic substance to be contained in the inorganic substance-containing layer (1). Further, the sputtering is suitable when a metal such as gold, silver, copper, or aluminum, or a metal oxide such as titanium oxide, aluminum oxide, niobium oxide, ITO, or IZO is used as an inorganic substance to be contained in the inorganic substance-containing layer (1).

The pressure at the time of formation of the cover layer (I) by PVD is preferably 1×10⁻⁷ Pa or more and 20 Pa or less, more preferably 1×10⁻⁶ Pa or more and 10 Pa or less, further preferably 1×10⁻⁴ Pa or more and 5 Pa or less from the viewpoint of the unevenness structure forming property and the vacuum exhaust capacity.

When the cover layer (I) is formed by the surface treatment through the dry process, a raw material for forming the cover layer (I) may be appropriately selected to perform the dry process.

For example, when the inorganic substance-containing layer containing DLC as an inorganic substance is formed through CVD, hydrocarbon or the like may be used as a raw material. Specific examples thereof include alicyclic hydrocarbons represented by the formula C₄ₙ₊₆H₄ₙ₊₁₂ (n is an integer of 1 or more), for example, alicyclic hydrocarbons such as adamantan, diamantan, triamantan, pentamantan, and tetramantan, aromatic hydrocarbons such as benzene, toluene, and xylene, and aliphatic hydrocarbons such as acetylene, ethylene, propylene, methane, ethane, and propane. As these raw materials, each compound may be used alone, or two or more thereof may be used in mixture. Further, the raw material gas may be diluted with rare gas such as argon (Ar), or helium (He) before use.

Of course, the inorganic substance-containing layer (1) containing DLC may be formed through PVD.

Further, when, for example, the inorganic substance-containing layer containing silicon carbide as an inorganic substance is formed through CVD, organosilane such as tetramethylsilane or hexamethyldisilane may be used as a raw material. Further, it may be one which is a mixed gas of a silicon component such as silane or disilane and a carbon component such as alkane having 1 to 6 carbon atoms and with which hydrogen gas may be appropriately mixed. However, other raw materials may be used as long as silicon carbide can be formed.

Further, for example, when the fluororesin layer is formed through CVD, a fluorine-based gas such as CF₄, C₂F₄, C₂F₆, C₃F₈, C₄F₈, or C₅F₈ may be used as a raw material.

Further, for example, when the inorganic substance-containing layer containing silicon oxide/carbide as an inorganic substance is formed through CVD, a silicon compound as a raw material (hereinafter, also referred to as "silicon compound raw material") may be used. The silicon compound raw material may be used in any of gas, liquid, and solid states at room temperature under normal pressure. In the case of a gas, it may be introduced as it is into a reactor (for example, a discharge space). In the case of a liquid or a solid, it may be used by being evaporated by means such as heating, bubbling, depressurization, and ultrasonic irradiation. Further, dilution with a solvent may be carried out before use, and as the solvent organic solvents such as methanol, ethanol, and n-hexane and a mixed solvent thereof may be used.

Examples of the silicon compound raw material include silane, tetramethoxysilane, tetraethoxysilane, tetran-propoxysilane, tetraisopropoxysilane, tetran-butoxysilane, tetrat-butoxysilane, dimethyldimethoxysilane, dimethyldiethoxysilane, diethyldimethoxysilane, diphenyldimethoxysilane, methyltriethoxysilane, ethyltrimethoxysilane, phenyltriethoxysilane, (3,3,3-trifluoropropyl)trimethoxysilane, hexamethyldisiloxane, bis(dimethylamino)dimethylsilane, bis(dimethylamino)methylvinylsilane, bis(ethylamino)dimethylsilane, N,O-bis(trimethylsilyl)acetamide, bis(trimethylsilyl)carbodiimide, diethylaminotrimethylsilane, dimethylaminodimethylsilane, hexamethyldisilazane, hexamethylcyclotrisilazane, heptamethyldisilazane, nonamethyltrisilazane, octamethylcyclotetrasilazane, tetrakis(dimethylamino)silane, tetraisocyanatesilane, tetramethyldisilazane, tris(dimethylamino)silane, triethoxyfluorosilane, allyldimethylsilane, allyltrimethylsilane, benzyltrimethylsilane, bis(trimethylsilyl)acetylene, 1,4-bistrimethylsilyl- 1,3-butadiine, di-t-butylsilane, 1,3-disilabutane, bis(trimethylsilyl)methane, cyclopentadienyltrimethylsilane, phenyldimethylsilane, phenyltrimethylsilane, propargyltrimethylsilane, tetramethylsilane, trimethylsilylacetylene, 1-(trimethylsilyl)-1-propine, tris(trimethylsilyl)methane, tris(trimethylsilyl)silane, vinyltrimethylsilane, hexamethyldisilane, octamethylcyclotetrasiloxane, tetramethylcyclotetrasiloxane, hexamethylcyclotetrasiloxane, and methylsilicate (for example, "methyl silicate 51" manufactured by COLCOAT Co., Ltd.).

In the surface treatment by the dry process in step 3, the cover layer (I) may not be formed. The surface treatment in the case where the cover layer (I) is not formed is not particularly limited as long as the resin layer (I) precursor can buckle by the surface treatment so as to form the unevenness containing the wrinkle structure, but a plasma treatment, etc. may be exemplified.

Although there is no particular limitation, the plasma treatment may be performed by methods such as vacuum and reduced-pressure plasma treatments, and among these, the vacuum plasma treatment is preferable. Further, in the plasma treatment, gas may be formed into plasma to perform the plasma treatment. Examples of the type of gas to be used include oxygen gas, hydrogen gas, nitrogen gas, and rare gas such as argon and helium. The gas may be used alone or in mixture of two or more thereof. Among these, argon is preferable.

In the present embodiment, as described above, the surface treatment is performed through the dry process, to the resin layer (I) precursor which has not been sufficiently cured. Therefore, in order to stably form the wrinkle structure, until the resin layer (I) precursor is transferred to the surface treatment using the dry process (step 3) after semi-curing (step 2), the time or the storage temperature is preferably adjusted.

The interval between step 2 and step 3 (that is, the time until the surface treatment by the dry process is started after heating and/or active energy ray irradiation are ended) is not particularly limited as long as the resin layer (I) precursor is in a desired semi-cured state when the surface treatment is started, but is, for example, 24 hours or less, preferably 10 h or less, more preferably 5 h or less. The lower limit of the interval is not particularly limited as long as it is 0 min or more.

Further, although there is no particular limitation, in the interval between step 2 and step 3, the base material (I) on which the resin layer (I) precursor is formed may be left at a temperature of, for example, 0°C or more and 40°C or less, preferably 5°C or more and 30°C or less.

Further, when the interval time is long, heating conditions, irradiation conditions for active energy rays and the like in step 2 may be appropriately selected in consideration of a case where curing progresses between step 2 and step 3 as well.

In this manufacturing method, through steps 1 to 3, or step 1 and step 3, it is possible to form the unevenness containing the wrinkle structure on the surface of the resin layer (I) or the surface of the cover layer (I) while forming the resin layer (I), or the resin layer (I) and the cover layer (I) on the base material (I).

### [Step 4]

In this manufacturing method, the following step 4 may be further provided after steps 1 to 3, or step 1 and step 3.

Step 4: a step of forming the cover layer (I) on the one surface side of the base material (I) subjected to the surface treatment in step 3 or forming the over cover layer (I) on the cover layer (I) formed through the surface treatment.

When this manufacturing method includes step 4, it is possible to form the cover layer (I) on the resin layer (I) subjected to the above-described surface treatment, or the over cover layer (I) in the case where the cover layer (I) is already present.

In step 4, the cover layer (I) or the over cover layer (I) may be formed by the same method as the method for forming the inorganic substance-containing layer or the resin layer (I) in step 3. That is, the inorganic substance-containing layer, and the resin layer (I) may be formed by the surface treatment through the dry process. The specific descriptions on the method of forming each of these layers are the same as described in step 3, and thus, the descriptions will be omitted.

Further, in step 4, the cover layer (I) or the over cover layer (I) may also be formed by a method other than the dry process. For example, in this formation, a coating liquid that contains an inorganic substance or a resin component, or an inorganic substance and a resin component may be applied to the one surface side of the base material (I) so that a coating film is formed, and then if necessary, the coating film may be dried or cured.

### <Application of laminate (I)>

The laminate (I) may be suitably used for food packaging, daily necessities packaging, industrial products and medicine packaging and the like. Specifically, it may be used as packaging materials for foods, cosmetics, daily necessities such as shampoos and conditioners, medical products, and various industrial products, e.g., various containers such as a bottle container and a pouch container, and films. In the packaging material, as water repellency and oil repellency are given, a suitable use as a constituent member for preventing adhesion of contents is possible.

Further, the laminate (I) may also be used for an optical material. Examples of the optical material include a window glass, a lens, and a substrate. In the optical material, cloudiness is given due to the unevenness of the wrinkle structure so that the haze, and the light transmission of the optical material may be controlled.

In the laminate (I), according to an application, a coat layer may be provided on the resin layer (I), the cover layer (I) or the over cover layer (I) which becomes the outermost surface of the laminate (I) to the extent that the effect of the present embodiment is not impaired. For example, in the application of adhesion prevention, by providing a coat layer having a liquid repellent effect, it is possible to impart the adhesion prevention property to the surface of the laminate (I).

### <<Second embodiment>>

In the laminate of the present invention, by using an inorganic substance-containing layer formed of a silicon-based compound, for a cover layer, the liquid repellency of the laminate can be improved.

A laminate according to a second embodiment of the present invention includes a base material, and a resin layer and an inorganic substance-containing layer provided in this order on at least one surface of the base material. The resin layer is formed of a heat- or active energy ray-curable resin composition, the inorganic substance-containing layer is formed of a silicon-based compound, and the outermost surface of the laminate on the one surface side of the base material has an unevenness.

As described above, in the laminate of the present embodiment, the liquid repellency on the laminate surface can be improved. Thus, for example, in the application to packaging materials, contents are less likely to adhere to the surface of the laminate.

Hereinafter, the laminate of the present embodiment will be described in more detail. In the following description, the laminate, the base material, the resin layer and the inorganic substance-containing layer in the present embodiment may be referred to as a "laminate (II)", a "base material (II)", a "resin layer (II)", and an "inorganic substance-containing layer (II)", respectively.

### <Unevenness of outermost surface>

The unevenness of the outermost surface of the laminate (II) preferably has a wrinkle structure. This wrinkle structure is the same as the wrinkle structure described in the laminate (I) of «first embodiment».

Further, suitable ranges of Ssk (degree of deviation) of the outermost surface of the laminate (II) are the same as those in the laminate (I) described in «first embodiment».

The outermost surface of the laminate (II) preferably has a specific surface area (S/A) of 1.005 or more. The specific surface area set as 1.005 or more means that the unevenness of the outermost surface is sufficiently large. Thus, the liquid repellency is improved, and, for example, in the application to packaging materials, it becomes easy to prevent contents from adhering to a packaging material. From this point of view, the specific surface area (S/A) is more preferably 1.01 or more, further preferably 1.05 or more.

Further, the specific surface area (S/A) is not particularly limited, but is preferably 2 or less, more preferably 1.7 or less, further preferably 1.5 or less, still further preferably 1.3 or less in order to prevent the unevenness from becoming too large and the structural strength from being reduced.

Sa (arithmetic mean roughness) of the outermost surface of the laminate (II) is not particularly limited, but is, for example, 50 nm or more. The Sa set as 50 nm or more means that the unevenness is sufficiently formed, and then the liquid repellency of the laminate (II) is further improved, and for example, in the application to packaging materials, it becomes easy to prevent contents from adhering to the laminate (II). From this point of view, the Sa (arithmetic mean roughness) is preferably 100 nm or more, more preferably 300 nm or more.

Further, the Sa (arithmetic mean roughness) is not particularly limited but is preferably 3000 nm or less, more preferably 1800 nm or less, further preferably 1300 nm or less from the viewpoint of maintaining the physical strength of the unevenness structure.

Sz (maximum height) of the outermost surface of the laminate (II) is not particularly limited, but is preferably 1000 nm or more, more preferably 2000 nm or more, further preferably 3000 nm or more. Sz equal to or higher than these lower limit values means that sufficient buckling has progressed, and a sufficient unevenness is formed. Therefore, the liquid repellency of the laminate (II) is likely to be improved, and, for example, in the application to packaging materials, it becomes easy to prevent contents from adhering to the laminate (II).

The Sz (maximum height) is not particularly limited, but is preferably 20000 nm or less, more preferably 15000 nm or less, further preferably 10000 nm or less from the viewpoint of preventing the unevenness from becoming too large and the structural strength from being reduced.

In the laminate (II), the contact angle with pure water is preferably 80° or more. When the contact angle is set as 80° or more, the liquid repellency is further increased, and, for example, in the application to packaging materials, contents are less likely to adhere to the surface of the laminate (II). The contact angle of the laminate (II) can be measured on one surface of the laminate (II) on which the resin layer (II), and a cover layer (the inorganic substance-containing layer (II)) are provided.

The contact angle with pure water is more preferably 90° or more, further preferably 100° or more from the viewpoint of liquid repellency.

The contact angle with pure water is, for example, 150° or less although its upper limit is not particularly limited.

### <Base material (II) and resin layer (II)>

The base material (II) and the resin layer (II) are the same as the base material (I) and the resin layer (I), respectively, described in «first embodiment».

### <Inorganic substance-containing layer (II)>

As described above, in the laminate (II), the inorganic substance-containing layer (II) is formed on the resin layer (II). Since the laminate (II) has the inorganic substance-containing layer (II), the liquid repellency is improved. Further, since the barrier property can be secured by the inorganic substance-containing layer (II), for example, in the case where the base material (II) is a container, elution of contents can be prevented.

The inorganic substance-containing layer (II) is a layer formed of a silicon-based compound that is an inorganic substance, and is a layer containing the silicon-based compound which is the inorganic substance as a main component. Containing the silicon-based compound as the main component means that the silicon-based compound accounts for 50% by mass or more, preferably 70% by mass or more, more preferably 80% by mass or more, further preferably 90% by mass or more (including 100% by mass) of the inorganic substance-containing layer (II).

The silicon-based compound is, for example, at least one selected from silicon oxide, silicon nitride, silicon oxide/nitride, silicon oxide/carbide, silicon oxide/carbide/nitride, silicon carbide, fluorine-containing silicon oxide, and fluorine-containing silicon carbide.

As the silicon-based compound, among the above, from the viewpoint of liquid repellency, and the viewpoint of ease of practical use, silicon oxide/carbide, silicon carbide, silicon oxide/nitride, silicon nitride, and silicon oxide/carbide/nitride are preferable, and above all, silicon oxide/carbide, and silicon carbide are more preferable. From the viewpoint of water repellency, silicon oxide/carbide is further preferable.

From the viewpoint of improving water repellency, silicon oxide/carbide is preferably silicon oxide/carbide represented by SiOₓC_{y} (0.5≤x≤1.5, 1.2≤y≤2.9). The composition thereof can be confirmed by XPS analysis or the like.

In the composition, the oxygen (O) component becomes an index of the degree of hydrophilicity of the obtained silicon oxide/carbide film itself. Meanwhile, the carbon (C) component becomes an index of water repellency. The larger the numerical value of x, the stronger the hydrophilicity. In general, since there is a tendency to further increase the ratio of the oxygen (O) component in order to impart hydrophilicity, the x value is usually set in a range larger than 1.5. However, when x is set as 1.5 or less, it is possible to form a good water-repellent film. Further, when x is set as 0.5 or more, it is possible to prevent the inorganic substance-containing layer (II) from becoming yellowish and having a low transparency.

The value of x is more preferably 0.5 or more and 1.2 or less, and further, the value of y is more preferably 1.2 or more and 2.5 or less.

The inorganic substance-containing layer (II) is preferably formed by a dry process as described below, but does not necessarily need to be formed through the dry process. When the inorganic substance-containing layer (II) is not formed through the dry process, a wrinkle structure may be formed on the resin layer (II) in advance through another dry process, and then the inorganic substance-containing layer (II) may be formed.

The thickness (ta) of the inorganic substance-containing layer (II) is preferably 10 nm or more and 250 nm or less. In the case where the thickness (ta) of the inorganic substance-containing layer (II) falls within the above range, when a film is formed through a dry process, an appropriate film stress occurs, and then a compressive stress is appropriately applied to the resin layer (II), so that it becomes easy to form an unevenness having a desired roughness and structure. From the viewpoint of facilitating the formation of a desired unevenness on the outermost surface of the laminate (II), the thickness (ta) of the inorganic substance-containing layer (II) is more preferably 15 nm or more and 200 nm or less, further preferably 20 nm or more and 150 nm or less.

Further, when the inorganic substance-containing layer (II) is formed into a thick film, it is possible to impart the barrier property. From the viewpoint of increasing the barrier property, the thickness (ta) of the inorganic substance-containing layer (II) is preferably 100 nm or more and 600 nm or less. When it is greater than 600 nm, the film stress may remain in the inorganic substance-containing layer (II), causing brittleness in some cases.

### [Thickness ratio (ta/tb) of inorganic substance-containing layer (II) and resin layer (II)]

In the present embodiment, the ratio (ta/tb) of the thickness (ta, unit: nm) of the inorganic substance-containing layer (II) to the thickness (tb, unit: µm) of the resin layer (II) is preferably 0.1 or more and 3500 or less. In the case where the thickness ratio falls within the above range, when the inorganic substance-containing layer (II) is formed through a dry process as described below, it becomes easy to form an unevenness having a desired roughness and shape through the dry process. Further, when the unevenness is formed on the surface of the resin layer (II) in advance before the inorganic substance-containing layer (II) is formed, the smoothing of the unevenness by the inorganic substance-containing layer (II) may be prevented.

From the viewpoint of facilitating the formation of a desired unevenness on the outermost surface of the laminate (II), the thickness ratio is more preferably 1 to 500, further preferably 2 or more and 250 or less, still further preferably 3 or more and 100 or less.

The inorganic substance-containing layer (II) may be multi-layered, and, for example, first and second inorganic substance-containing layers (II) formed of silicon-based compounds having different compositions each other may be provided.

Further, it is preferable that the inorganic substance-containing layer (II) is formed so as to be in direct contact with the above-described resin layer (II). When the formation is carried out such that direct contact is made, it is possible to form the inorganic substance-containing layer (II) while forming the unevenness through a simplified manufacturing method.

Further, it is preferable that the inorganic substance-containing layer (II) constitutes the outermost surface of the laminate (II). When the outermost surface is constituted by the inorganic substance-containing layer (II), it becomes easy to increase the liquid repellency by the inorganic substance-containing layer (II).

In a preferred example of the present embodiment, in the laminate (II), the resin layer (II) is provided on one surface of the substrate (II), and the inorganic substance-containing layer (II) is laminated on the resin layer (II). In addition, the surface of the inorganic substance-containing layer (II) constitutes the outermost surface of the laminate (II), and the unevenness is formed on the outermost surface. Meanwhile, as long as the effect of the present invention is not impaired, another layer may also be provided between the inorganic substance-containing layer (II) and the resin layer (II). Further, as long as the effect of the present embodiment is not impaired, another layer may also be provided on the inorganic substance-containing layer (II).

Such another layer may be a layer formed by an inorganic substance other than the silicon compound, and specific examples thereof include layers formed by inorganic substances such as diamond-like carbon (DLC), metals other than silicon, e.g., aluminum, zinc, titanium, niobium, gold, silver, copper, indium, tin, and nickel, and oxides, nitrides, and carbides of these metals. Specific examples of the inorganic substance include diamond-like carbon, aluminum-based compounds such as aluminum oxide, aluminum nitride, aluminum oxide/nitride, and aluminum oxide/carbide, niobium-based compounds such as niobium oxide, zinc-based compounds such as zinc oxide, and titanium-based compounds such as titanium oxide.

The layer formed of these inorganic substances may be formed by a surface treatment through a dry process described below.

Further, the resin layer (II) may be formed so as to be in direct contact with the top of the base material (II), but a layer such as an adhesive layer may be appropriately provided between the resin layer (II) and the base material (II).

### <Manufacturing method of laminate (II)>

The laminate (II) may be manufactured by any manufacturing method, but the same method as the manufacturing method of the laminate (I) described in «first embodiment» is preferable.

That is, the manufacturing method of the laminate (II) according to a preferred example includes the following steps 1 to 3.
Step 1: a step of applying a curable resin composition on at least one surface of the base material (II) to form a resin layer (II) precursor
Step 2: a step of semi-curing the resin layer (II) precursor formed in step 1
Step 3: a step of further performing a surface treatment through a dry process to the resin layer (II) precursor semi-cured in step 2, so as to form an unevenness on the surface on the one surface side of the base material (II)

Step 2 may be omitted. Therefore, in step 3, the surface treatment may be carried out on the uncured resin layer (II) precursor.

Further, in this manufacturing method, the inorganic substance-containing layer (II) formed of the silicon-based compound may be formed through the dry process in step 3, or step 4 of forming the inorganic substance-containing layer (II), on the one surface side of the base material (II) subjected to the surface treatment through the dry process may be further provided.

The unevenness formed in step 3 may have a wrinkle structure as described above. Further, in step 3, the inorganic substance-containing layer (II) may be formed by the dry process, but a dry process treatment that does not involve film formation may be performed without forming the inorganic substance-containing layer (II). Further, in step 3, a layer other than the inorganic substance-containing layer (II) (for example, a layer formed of an inorganic substance other than the silicon-based compound) may be formed through CVD or PVD. Even if a layer other than the inorganic substance-containing layer (II) is formed, it is possible to form an unevenness having a wrinkle structure on the surface of a layer other than the inorganic substance-containing layer (II) through CVD or PVD.

In this manufacturing method, as described above, step 4 may be further provided. Step 4 is a step of forming the inorganic substance-containing layer after steps 1 to 3, or after step 1 and step 3.

Details of each step except the points described above are the same as described in the first embodiment.

### <Application of laminate (II)>

The laminate (II) may be used for food packaging, daily necessities packaging, industrial products and medicine packaging and the like. Specifically, it may be used as packaging materials for foods, cosmetics, daily necessities such as shampoos and conditioners, medical products, and various industrial products, e.g., various containers such as a bottle container and a pouch container, and films. Among these, the laminate (II) may be suitably used for food packaging, and daily necessities packaging. In the packaging material, as liquid repellency is given, a suitable use as a constituent member for preventing adhesion of contents is possible.

In the laminate (II), according to an application, a coat layer may be provided on the resin layer (II) or the inorganic substance-containing layer (II) which becomes the outermost surface of the laminate (II) to the extent that the effect of the present invention is not impaired. For example, by providing a coat layer having a liquid repellent effect to the outermost surface, it is possible to improve the liquid repellency of the surface of the laminate (II).

### «Third embodiment»

The laminate of the present invention has a fluorine-based compound on the surface of the cover layer so that the liquid repellency of the laminate can be improved.

A laminate according to a third embodiment of the present invention includes a base material, and a resin layer and a cover layer provided in this order on at least one surface of the base material. The resin layer is formed of a heat- or active energy ray-curable resin composition, the cover layer has a fluorine-based compound on at least the surface thereof, and the outermost surface of the laminate on the one surface side of the base material has an unevenness.

Since the laminate according to the present embodiment has the above configuration, the liquid repellency on the surface of the laminate may be improved. Thus, for example, in the application to packaging materials, contents are less likely to adhere to the surface of the laminate.

Hereinafter, the laminate of the present embodiment will be described in more detail. In the following description, the laminate, the base material, the resin layer and the cover layer in the present embodiment may be referred to as a "laminate (III)", a "base material (III)", a "resin layer (III)", and a "cover layer (III)", respectively.

### <Unevenness of outermost surface>

The unevenness of the outermost surface of the laminate (III) preferably has a wrinkle structure. This wrinkle structure is the same as the wrinkle structure described in the laminate (I) of «first embodiment».

Further, a suitable ranges of Ssk (degree of deviation) of the outermost surface of the laminate (III) is the same as those in the laminate (I) described in «first embodiment».

The outermost surface of the laminate (III) preferably has a specific surface area (S/A) of 1.005 or more. The specific surface area set as 1.005 or more means that the unevenness of the outermost surface is sufficiently large. Thus, the liquid repellency is improved, and, for example, in the application to packaging materials, it becomes easy to prevent contents from adhering to a packaging material. From this point of view, the specific surface area (S/A) is more preferably 1.01 or more, further preferably 1.03 or more.

Further, the specific surface area (S/A) is not particularly limited, but is preferably 2 or less, more preferably 1.7 or less, further preferably 1.5 or less, still further preferably 1.3 or less in order to prevent the unevenness from becoming too large and the structural strength from being reduced.

Sa (arithmetic mean roughness) of the outermost surface of the laminate (III) is not particularly limited, but is, for example, 50 nm or more. The Sa set as 50 nm or more means that the unevenness is sufficiently formed, and then the liquid repellency of the laminate (III) is further improved, and for example, in the application to packaging materials, it becomes easy to prevent contents from adhering to the laminate (III). From this point of view, the Sa (arithmetic mean roughness) is preferably 100 nm or more, more preferably 300 nm or more.

Further, the Sa (arithmetic mean roughness) is not particularly limited but is preferably 3000 nm or less, more preferably 2000 nm or less, further preferably 1800 nm or less, still further preferably 1600 nm or less, particularly preferably 1500 nm or less from the viewpoint of maintaining the physical strength of the unevenness structure.

Sz (maximum height) of the outermost surface of the laminate (III) is not particularly limited, but is preferably 1000 nm or more, more preferably 2000 nm or more, further preferably 3000 nm or more. Sz equal to or higher than these lower limit values means that sufficient buckling has progressed, and a sufficient unevenness is formed. Therefore, the liquid repellency of the laminate (III) is likely to be improved, and, for example, in the application to packaging materials, it becomes easy to prevent contents from adhering to the laminate (III).

The Sz (maximum height) is not particularly limited, but is preferably 20000 nm or less, more preferably 15000 nm or less, further preferably 13000 nm or less, still further preferably 12000 nm or less from the viewpoint of preventing the unevenness from becoming too large and the structural strength from being reduced.

Further, in the laminate (III), the contact angle with pure water is preferably 100° or more. When the contact angle is set as 100° or more, the liquid repellency is further increased, and, for example, in the application to packaging materials, contents are less likely to adhere to the surface of the laminate (III). The contact angle of the laminate (III) may be measured on one surface of the laminate (III) on which the resin layer (III), and the cover layer (III) are provided.

The contact angle with pure water is more preferably 115° or more, further preferably 125° or more, still further preferably 130° or more, from the viewpoint of liquid repellency.

The contact angle with pure water is, for example, 150° or less although its upper limit is not particularly limited.

### <Base material (III) and resin layer (III)>

The base material (III) and the resin layer (III) are the same as the base material (I) and the resin layer (I), respectively, described in «first embodiment».

### <Cover layer (III)>

As described above, the laminate (III) has the cover layer (III) on the resin layer (III), and the cover layer (III) has a fluorine-based compound on at least the surface thereof. Since the laminate (III) includes the cover layer (III) having the fluorine-based compound on the surface thereof, as described above, the liquid repellency is improved. Further, since the barrier property may be secured by the cover layer (III), for example, in the case where the base material (III) is a container, elution of contents may be prevented.

The fluorine-based compound may be contained in the material itself forming the cover layer (III) so that the surface of the cover layer (III) may contain the fluorine-based compound, or the surface of the cover layer (III) may be fluorinated so that the fluorine-based compound is contained.

Specific examples of the cover layer (III) include an inorganic substance-containing layer, and a cover resin layer. Among these, the inorganic substance-containing layer is preferable from the viewpoint of further improving the liquid repellency.

### [Inorganic substance-containing layer]

The inorganic substance-containing layer is a layer formed by an inorganic substance, and containing the inorganic substance as a main component. Containing the inorganic substance as the main component means that the inorganic substance accounts for 50% by mass or more, particularly 70% by mass or more, particularly 80% by mass or more, particularly 90% by mass or more, particularly 100% by mass of the inorganic substance-containing layer. The inorganic substance-containing layer may be formed by an inorganic substance having good adhesion to the resin layer. Further, it is preferable that the inorganic substance-containing layer is formed by using a material that can be easily formed in film on the resin layer through a dry process.

The inorganic substance-containing layer of the present embodiment is preferably formed of the inorganic substance that is at least one selected from diamond-like carbon (DLC), metal, metal oxide, metal nitride, metal carbide, or composites thereof. In these inorganic substances, fluorides such as calcium fluoride may be further included, or fluorine-containing substances may be used as the inorganic substance as described below. When fluoride is used or fluorine is contained in the inorganic substance-containing layer, the surface of the cover layer (III) can contain the fluorine-based compound without fluorination treatment on the surface of the inorganic substance-containing layer.

The metal referred to herein also includes so-called semi-metals such as silicon, boron, and germanium.

In the inorganic substance-containing layer, examples of the metal constituting metal, metal oxide, metal nitride, metal carbide, or composites thereof include silicon, aluminum, zinc, titanium, niobium, gold, silver, copper, indium, tin, and nickel, and among these, silicon is preferable from the viewpoint of liquid repellency.

Suitable specific examples of the inorganic substance used for the inorganic substance-containing layer include silicon-based compounds such as silicon oxide, silicon nitride, silicon oxide/nitride, silicon oxide/carbide, silicon oxide/carbide/nitride, and silicon carbide, aluminum-based compounds such as aluminum oxide, aluminum nitride, aluminum oxide/nitride, and aluminum oxide/carbide, niobium-based compounds such as niobium oxide, zinc-based compounds such as zinc oxide, titanium-based compounds such as titanium oxide, diamond-like carbon (DLC), and conductive oxides such as ITO and IZO. Further, suitable specific examples of the fluorine-containing inorganic substance include fluorine-containing silicon-based compounds such as fluorine-containing silicon oxide, and fluorine-containing silicon carbide, and fluorine-containing diamond-like carbon (fluorine-containing DLC).

The inorganic substance used for the inorganic substance-containing layer may be used alone or in combination of two or more thereof.

From the viewpoint that the hardness of the laminate (III) may be increased, and thus the durability of the laminate (III) may be improved, and from the viewpoint of the liquid repellency, among the above, the inorganic substance-containing layer is more preferably a layer containing at least DLC, silicon oxide, silicon oxide/carbide, silicon carbide, fluorine-containing silicon carbide (fluorine-containing SiC), or fluorine-containing DLC. Further, among these, a silicon carbide layer formed of silicon carbide, a DLC layer formed of DLC, and a fluorine-containing DLC layer formed of fluorine-containing DLC are more preferable.

When silicon carbide, DLC or fluorine-containing DLC is used, the film stress occurring during the formation of the inorganic substance-containing layer tends to be increased, and then it becomes easy to form the wrinkle structure, and it also becomes easy to improve the liquid repellency. Further, when fluorine-containing DLC is used, the surface may contain the fluorine-based compound without fluorination treatment on the surface of the cover layer (III).

Whether the surface of the cover layer (III) contains the fluorine-based compound can be determined by a surface chemical analysis such as XPS (X-ray photoelectron spectroscopy), or TOF-SIMS (time-of-flight secondary ion mass spectrometry).

### [Cover resin layer]

The cover resin layer of the present embodiment is the same as the cover resin layer in the cover layer (I) described in «first embodiment».

### [Thickness (ta) of cover layer (III)]

The thickness (ta) of the cover layer (III) of the present embodiment is preferably 10 nm or more and 250 nm or less. In the case where the thickness (ta) of the cover layer (III) falls within the above range, when a film is formed through a dry process, an appropriate film stress occurs, and then a compressive stress is appropriately applied to the resin layer (III), so that it becomes easy to form an unevenness having a desired roughness and structure. From the viewpoint of facilitating the formation of a desired unevenness on the outermost surface of the laminate (III), the thickness (ta) of the cover layer (III) is more preferably 15 nm or more and 200 nm or less, further preferably 20 nm or more and 150 nm or less.

Further, when the cover layer (III) is formed into a thick film, it is possible to impart the barrier property. From the viewpoint of increasing the barrier property, the thickness (ta) of the cover layer (III) is preferably 100 nm or more and 600 nm or less. When it is greater than 600 nm, a film stress may remain in the cover layer (III), causing brittleness in some cases.

### [Thickness ratio (ta/tb) of cover layer (III) and resin layer (III)]

In the present embodiment, the ratio (ta/tb) of the thickness (ta, unit: nm) of the cover layer (III) to the thickness (tb, unit: µm) of the resin layer (III) is preferably 0.1 or more and 3500 or less. In the case where the thickness ratio falls within the above range, when the cover layer (III) is formed through a dry process as described below, it becomes easy to form an unevenness having a desired roughness and shape through the dry process. Further, when the unevenness is formed on the surface of the resin layer (III) in advance before the cover layer (III) is formed, the smoothing of the unevenness by the cover layer (III) may be prevented.

From the viewpoint of facilitating the formation of a desired unevenness on the outermost surface of the laminate (III), the thickness ratio is more preferably 1 or more and 500 or less, further preferably 2 or more and 250 or less, still further preferably 3 or more and 200 or less.

The cover layer (III) may be multi-layered, and, for example, first and second cover layers (III) formed of inorganic substance-containing layers having different compositions each other may be provided. Further, for example, first and second cover layers (III) formed of cover resin layers having different compositions each other may be provided. Further, it may be a laminate of the inorganic substance-containing layer and the cover resin layer. Meanwhile, in this specification, a layer formed on the outermost surface of the cover layer (III) and formed by the fluorine-based compound described below is referred to as a "fluorine-based compound layer" described below.

Further, it is preferable that the cover layer (III) is formed so as to be in direct contact with the resin layer (III). When the formation is carried out such that direct contact is made, it is possible to form the cover layer (III) while forming the unevenness through a simplified manufacturing method.

### [Fluorination treatment]

As described above, the surface of the cover layer (III) may contain the fluorine-based compound by being subjected to a fluorination treatment. By performing the fluorination treatment, the fluorine-based compound layer may be formed on the surface of the cover layer (III) by the fluorine-based compound, but if the fluorine-based compound is attached to the surface of the cover layer (III), it is not necessary to form the fluorine-based compound layer.

The fluorine-based compound layer may be formed of, for example, the fluorine-based compound alone, but may be formed of the fluorine-based compound and a compound other than the fluorine-based compound. The fluorine-based compound layer may contain the fluorine-based compound as a main component. Containing the fluorine-based compound as the main component means that the fluorine-based compound accounts for 50% by mass or more, particularly 70% by mass or more, particularly 80% by mass or more, particularly 90% by mass or more, particularly 100% by mass of the fluorine-based compound layer.

The thickness of the fluorine-based compound layer is not particularly limited as long as the unevenness of the wrinkle structure formed by the resin layer (III) appears on the outermost surface, but is preferably 1 nm or more and 200 nm or less, more preferably 3 nm or more and 100 nm or less, further preferably 5 nm or more and 50 nm or less.

As described below, the fluorination treatment may be performed by attaching, for example, a fluorine-based compound having a reactive group capable of reacting with a functional group of the surface of the cover layer (III) (hereinafter, also referred to as a "reactive group-containing fluorine-based compound"), to the surface of the cover layer (III). As the reactive group-containing fluorine-based compound, a fluorine-based silane coupling agent is preferable. The reactive group-containing fluorine-based compound may be attached to the surface of the cover layer (III) by PVD, wet treatment, or the like.

The fluorine-based silane coupling agent is not particularly limited as long as it is a fluorine-containing silane coupling agent, but is preferably a compound having an alkoxy group (Si-OR) directly bonded to Si, as a reactive group. Examples of the alkoxy group include alkoxy groups having 1 to 4 carbon atoms, such as a methoxy group, an ethoxy group, a propoxy group, and a butoxy group. Further, the alkoxy group is preferably an alkoxy group having 1 to 2 carbon atoms, and is more preferably a methoxy group from the viewpoint of reaction rate. The fluorine-based silane coupling agent preferably contains two or more alkoxy groups, or may contain two or more types of alkoxy groups. Further, the alkoxy group (Si-OR) directly bonded to Si may react with water in environment to form a silanol group (Si-OH), and thus a silanol group may be contained. The fluorine-based silane coupling agent may be easily bonded to the surface of the cover layer (III) by containing the alkoxy group directly bonded to Si.

Further, the fluorine-based silane coupling agent preferably contains a perfluoroalkyl group, and in particular, more preferably contains a perfluoroalkylether group. The perfluoroalkylether group is a functional group represented by -ORf (Rf is a perfluoroalkyl group).

The perfluoroalkylether group may be bonded to Si via an unsubstituted or substituted divalent organic group having 2 to 12 carbon atoms, being preferably a divalent hydrocarbon group having 2 to 12 carbon atoms, which may contain one type or two or more types of structures selected from the group consisting of an amide bond, an ether bond, an ester bond, a vinyl bond, and a diorganosilylene group such as a dimethylsilylene group.

The fluorine-based silane coupling agent may be, preferably trialkoxysilane, or dialkoxysilane, having a perfluoroalkylether group and, more preferably, trimethoxysilane having a perfluoroalkylether group.

As the fluorine-based silane coupling agent, a fluorine-based silane coupling agent not containing the perfluoroalkylether group may be used, and examples thereof include trimethoxy(3,3,3-trifluoropropyl)silane, triethoxy(3,3,3-trifluoropropyl)silane, trimethoxy(1H,1H,2H,2H-nonafluorohexyl)silane, triethoxy(1H,1H,2H,2H-nonafluorohexyl)silane, trimethoxy- 1H,1H,2H,2H-tridecafluoro-n-octylsilane, triethoxy-1H,1H,2H,2H-tridecafluoro-n-octylsilane, trimethoxy-1H,1H,2H,2H-heptadecafluorodecylsilane, triethoxy- 1H, 1H,2H,2H-heptadecafluorodecylsilane, trimethoxy[5,5,6,6,7,7,7-heptafluoro-4,4-bis(trifluoromethyl)heptyl]silane, and triethoxy[5,5,6,6,7,7,7-heptafluoro-4,4-bis(trifluoromethyl)heptyl]silane.

Further, the fluorine-based silane coupling agent may have two or more silicon atoms (Si), or may have a siloxane structure.

When the surface treatment is performed by the reactive group-containing fluorine-based compound, the surface of the cover layer (III) may have a functional group that reacts with the reactive group, such as a hydroxy group. When the fluorination treatment is performed by the reactive group-containing fluorine-based compound such as the fluorine-based silane coupling agent, the cover layer (III) is preferably an inorganic substance-containing layer, and is preferably an inorganic substance-containing layer containing silicon oxide, silicon nitride, silicon oxide/nitride, silicon oxide/carbide, silicon oxide/carbide/nitride, silicon carbide, DLC, aluminum oxide, niobium oxide, or the like.

The fluorination treatment may be performed by attaching a fluorine-based resin to the surface of the cover layer (III) by, for example, CVD or wet treatment. Examples of the fluorine-based resin include polytetrafluoroethylene, tetrafluoroethylene-ethylene copolymers, polyhexafluoropropylene, tetrafluoroethylene-hexafluoropropylene copolymers, and tetrafluoroethylene-perfluoroalkoxyethylene copolymers.

When the fluorine-based resin is used, the fluorine-based compound layer may be formed by the fluorine-based compound. The fluorine-based compound layer may be formed of the fluorine-based compound alone, but another compound may be contained. For example, when a wet treatment is performed, besides the fluorine-based resin, a binder resin, or the like may be contained.

Another fluorination treatment than the above may be carried out as long as a fluorine atom can be introduced into the surface of the cover layer (III). For example, through a plasma treatment or the like, a fluorine atom may be introduced into the surface of the cover layer (III). Examples of the type of gas to be used include fluorine-based gases such as CF₄, SF₆, NF₃, BF₃, and XeF₂. These gases may be used alone or in mixture of two or more thereof. A rare gas such as argon or helium may be used in mixture with these fluorine-based gases.

In a preferred example of the present embodiment, in the laminate (III), the resin layer (III) is provided on one surface of the substrate (III), and the cover layer (III) is laminated on the resin layer (III). In the laminate (III), the fluorine-based compound is attached to the surface of the cover layer (III), and thus, the surface of the cover layer (III) contains the fluorine compound. The surface of the cover layer (III) 13 constitutes the outermost surface of the laminate 10, and the outermost surface has the unevenness. Meanwhile, in the present embodiment, as long as the effect of the present invention is not impaired, a layer other than the fluorine-based compound layer (III) may be provided on the surface of the cover layer (III).

Further, in another preferred example of the present embodiment, in the laminate (III), the resin layer (III) is provided on one surface of the substrate (III), and the cover layer (III) is laminated on the resin layer (III). Further, the fluorine-based compound layer is laminated on the cover layer (III), and thus, the surface of the cover layer (III) contains the fluorine-based compound. The surface of the fluorine-based compound layer constitutes the outermost surface of the laminate (III), and the outermost surface has the unevenness. Meanwhile, as long as the effect of the present invention is not impaired, a layer other than the fluorine-based compound layer may be provided on the fluorine-based compound layer.

Further, in each example of the present embodiment, as long as the effect of the present invention is not impaired, another layer may be provided between the cover layer (III) and the resin layer (II). Further, the resin layer (III) may be formed so as to be in direct contact with the top of the base material (III), but a layer such as an adhesive layer may be appropriately provided between the resin layer (III) and the base material (III).

### <Manufacturing method of laminate (III)>

The laminate (III) may be manufactured by any manufacturing method, but the manufacturing method of the laminate (III) according to an example of the present embodiment includes the following steps 1 to 3.
Step 1: a step of applying a heat- or active energy ray-curable resin composition on at least one surface of the base material (III) to form a resin layer (III) precursor
Step 2: a step of semi-curing the resin layer (III) precursor formed in step 1
Step 3: a step of further performing a surface treatment through a dry process to the resin layer (III) precursor semi-cured in step 2, so as to form an unevenness on the surface on the one surface side of the base material (III)

Meanwhile, step 2 may be omitted. Therefore, in step 3, the surface treatment may be carried out on the uncured resin layer (III) precursor.

In this manufacturing method, the cover layer (III) may be formed through the dry process in step 3. Meanwhile, the cover layer (III) does not necessarily need to be formed through the dry process, and step 4 of forming the cover layer (III), on the one surface side of the base material (III) subjected to the surface treatment through the dry process may be further provided. Further, the unevenness formed in step 3 may be an unevenness containing a wrinkle structure.

Further, in this manufacturing method, although the surface of the cover layer (III) contains a fluorine-based compound, for example, the surface of the cover layer (III) may contain the fluorine-based compound by containing the fluorine-based compound in the material forming the cover layer (III). Further, this manufacturing method may include step 5 of performing a fluorination treatment to the surface of the cover layer (III) formed in step 3 or step 4. Through the fluorination treatment in step 5, the surface of the cover layer (III) may contain the fluorine-based compound.

In this manufacturing method, step 1, step 2, and step 3 are the same as described in the first embodiment, but CVD in step 3 can also be suitably used when an inorganic substance-containing layer containing fluorine-containing DLC as an inorganic substance is formed.

That is, CVD can be suitably used in forming an inorganic substance-containing layer containing DLC or fluorine-containing DLC as an inorganic substance, an inorganic substance-containing layer containing silicon carbide and/or silicon oxide as an inorganic substance, and a fluorine-based resin layer containing a fluorine-based resin or the like as a resin component.

For example, when the inorganic substance-containing layer containing the fluorine-containing DLC is formed through CVD, a fluorine-based gas or the like may be used as a raw material. The fluorine-based gas may be fluorocarbons such as CF₄, C₂F₄, C₂F₆, C₃F₈, C₄F₈, or C₅F₈. These raw materials may be used alone or two or more of the gases may be used in mixture. The above-described hydrocarbons may be further mixed thereto and then used. Further, the raw material gas may be diluted with a rare gas such as argon (Ar) or helium (He) before use.

Further, in step 3, the PVD is suitable when a metal, a metal oxide such as niobium oxide or silicon oxide, or a metal nitride is used as an inorganic substance to be contained in the inorganic substance-containing layer. Examples of the PVD include vacuum vapor deposition, sputtering, and ion plating, and among these, vacuum vapor deposition, and sputtering are preferable.

Further, the vacuum vapor deposition is suitable when a metal such as gold, silver, copper, or aluminum, a metal oxide such as silicon oxide, titanium oxide, or aluminum oxide, or a fluoride such as calcium fluoride is used as an inorganic substance to be contained in the inorganic substance-containing layer. Further, the sputtering is suitable when a metal such as gold, silver, copper, or aluminum, or a metal oxide such as titanium oxide, aluminum oxide, niobium oxide, ITO, or IZO is used as an inorganic substance to be contained in the inorganic substance-containing layer.

Other descriptions on step 1, step 2, and step 3 are the same as in the first embodiment, and thus the descriptions will be omitted.

In this manufacturing method, after steps 1 to 3, or after step 1 and step 3, as described above, step 4 of forming the cover layer (III) may be further provided.

When this manufacturing method includes step 4, in the case where the cover layer (III) is not formed through, for example, the dry process in step 3, it is possible to form the cover layer (III) on the resin layer subjected to the above-described surface treatment. Further, even when the cover layer (III) is formed in step 3, by carrying out step 4, it is possible to obtain a multi-layered cover layer (III). Further, step 4 may be repeatedly performed, and in this case as well, the cover layer (III) becomes multi-layered.

In step 4, the cover layer (III) may be formed by the same method as the method of forming the cover layer (III) in step 3. That is, it may be formed by the surface treatment through the dry process. Since specific descriptions on the forming method of each of these layers are the same as in step 3, the descriptions will be omitted.

In the laminate (III), the surface of the cover layer (III) formed in step 3 or step 4 may be subjected to the fluorination treatment (step 5). Through the fluorination treatment of step 5, the fluorine-based compound may be attached to or the fluorine-based compound layer may be formed on the surface of the cover layer (III). Even the cover layer (III) itself does not contain the fluorine-based compound, by carrying out step 5, it is possible to contain the fluorine-based compound in the surface of the cover layer (III).

The fluorination treatment may be performed by any of chemical vapor deposition (CVD), physical vapor deposition (PVD), plasma treatment, and wet treatment. Among these, CVD, PVD, or wet treatment is preferable.

The CVD is not particularly limited, and includes plasma CVD, thermal CVD, and cat-CVD (catalytic chemical vapor deposition method), but plasma CVD is preferable. The CVD is preferably used when, for example, a fluorine-based resin layer is formed as the fluorine-based compound layer. When the fluorine-based resin layer is formed through CVD, a fluorine-based gas such as CF₄, C₂F₄, C₂F₆, C₃F₈, C₄F₈, or C₅F₈ may be used as a raw material.

The PVD performed as the fluorination treatment may be vacuum vapor deposition, sputtering, or ion plating. Among these, vacuum vapor deposition, and sputtering are preferable. The vacuum vapor deposition is suitable when a reactive group-containing fluorine-based compound such as a fluorine-based silane coupling agent is attached to the surface of the cover layer (III).

Details of the CVD and the PVD performed as the fluorination treatment are the same as the contents described in step 3, and thus the details will be omitted.

The plasma treatment performed as the fluorination treatment may be performed by atmospheric plasma treatment. Further, in the plasma treatment, gas may be formed into plasma so as to perform the plasma treatment. As the gas to be used, a gas containing a fluorine-based gas may be used, and for example, a gas containing a fluorine-based gas such as CF₄, or SF₆ is preferably used. Further, as the gas to be used, the fluorine-based gas and a gas other than the fluorine-based gas may be used in combination. As the gas other than the fluorine-based gas, nitrogen, argon, or the like may be used.

In the wet treatment performed as the fluorination treatment, a processing liquid obtained by diluting the fluorine-based compound with a solvent may be applied to the surface of the cover layer (III) and then subjected to heating, drying, and the like so that the fluorine-based compound may be attached to the surface of the cover layer (III). The fluorine-based compound used for the wet treatment may be the reactive group-containing fluorine-based compound, and the fluorine-based silane coupling agent is preferable.

Further, the wet treatment performed as the fluorination treatment may also be used in the case where a fluorine-based resin is used as the fluorine-based compound. In the wet treatment, a processing liquid containing the fluorine-based resin may be applied to the surface of the cover layer (III) and then subjected to heating, drying, and the like so that the fluorine-based compound may be attached to the surface of the cover layer (III). At that time, the fluorine-based compound layer may be formed. Further, in the processing liquid, a resin component other than the fluorine-based resin may be appropriately blended as a binder resin.

The solvent to be used for the wet treatment is not particularly limited, but examples thereof include organic solvents exemplified as those used for the curable resin composition.

As a method of applying the processing liquid to the surface of the cover layer (III), it is possible to use conventionally known coating methods such as reverse gravure coating, direct gravure coating, roll coating, die coating, bar coating, curtain coating, spray coating, dip coating, and spin coating.

### <Application of laminate (III)>

The laminate (III) may be used for food packaging, daily necessities packaging, industrial products, medicine packaging, and the like. Specifically, it may be used as packaging materials for foods, cosmetics, daily necessities such as shampoos and conditioners, medical products, and various industrial products, e.g., various containers such as a bottle container and a pouch container, and films. Among these, the laminate (III) may be suitably used for food packaging, and daily necessities packaging. Further, the laminate (III) is suitable for liquid packaging in which a liquid is contained in the contents. In the packaging material, as liquid repellency is given, a suitable use as a constituent member for preventing adhesion of contents is possible.

### «Fourth embodiment»

In the laminate of the present invention, it is possible to control the unevenness structure and to adjust the handling property by forming the resin layer of an active energy ray-curable resin composition, and adjusting the content of the polymerization initiator in the active energy ray-curable resin composition.

A laminate according to a fourth embodiment of the present invention includes a base material; and a resin layer provided in this order on at least one surface of the base material. The resin layer is formed of an active energy ray-curable resin composition, and the outermost surface of the laminate on the one surface side of the base material has an unevenness. In the active energy ray-curable resin composition, active energy ray polymerization initiator is not contained, or is contained with the content ratio thereof being 2.5% by mass or less.

Hereinafter, the laminate of the present embodiment will be described in more detail. In the following description, the laminate, the base material, the resin layer, a cover layer and an over cover layer in the present embodiment may be referred to as a "laminate (IV)", a "base material (IV)", a "resin layer (IV)", a "cover layer (IV)", and an "over cover layer (IV)", respectively.

### <Unevenness of outermost surface>

The unevenness of the outermost surface of the laminate (IV) preferably has a wrinkle structure. This wrinkle structure is the same as the wrinkle structure described in the laminate (I) of «first embodiment».

Further, suitable ranges of Ssk (degree of deviation) and Sa (arithmetic mean roughness) of the outermost surface of the laminate (IV) are the same as those in the laminate (I) described in «first embodiment».

The outermost surface of the laminate (IV) preferably has a specific surface area (S/A) of 1.003 or more. The specific surface area set as 1.003 or more means that the unevenness of the outermost surface is sufficiently large. Thus, the liquid repellency is improved, and, for example, in the application to packaging materials, it becomes easy to prevent contents from adhering to a packaging material. From this point of view, the specific surface area (S/A) is more preferably 1.01 or more, further preferably 1.05 or more, still further preferably 1.1 or more.

Further, the specific surface area (S/A) is not particularly limited, but is preferably 2 or less, more preferably 1.7 or less, further preferably 1.5 or less, still further preferably 1.3 or less in order to prevent the unevenness from becoming too large and the structural strength from being reduced.

Sz (maximum height) of the outermost surface of the laminate (IV) is not particularly limited, but is preferably 400 nm or more, more preferably 500 nm or more, further preferably 600 nm or more. Sz equal to or higher than these lower limit values means that sufficient buckling has progressed and a high convex portion is formed. Therefore, for example, in the application to optical materials, it is possible to adjust the cloudiness.

The Sz (maximum height) is not particularly limited, but is preferably 20000 nm or less, more preferably 15000 nm or less, further preferably 10000 nm or less from the viewpoint of maintaining the physical strength of the unevenness structure.

In the laminate (IV), as described above, the surface uneven shape can be controlled. By adjusting the uneven shape, it is possible to control the haze value of the laminate (IV), and to exhibit good cloudiness. The haze value of the laminate (IV) is not particularly limited, and may be appropriately adjusted according to an application, but is, for example, 15% or more, preferably 30% or more, more preferably 40% or more in order to exhibit good cloudiness. Further, the haze value may be 100% or less although its upper limit is not particularly limited. The haze value may be measured by the method described in Examples.

### <Base material (IV)>

The base material (IV) is the same as the base material (I) described in «first embodiment».

### <Resin layer (IV)>

The resin layer (IV) is formed of an active energy ray-curable resin composition.

### [Active energy ray-curable resin composition]

### (Active energy ray polymerizable compound)

The active energy ray-curable resin composition of the present embodiment contains an active energy ray polymerizable compound. The active energy ray polymerizable compound is a compound that may be polymerized by being irradiated with active energy rays. The active energy ray-curable resin composition is preferably a UV ray curable resin composition.

As the resin component of the resin layer (IV) formed by the active energy ray-curable resin composition, a mixture of a prepolymer such as epoxy(meth)acrylate, urethane(meth)acrylate, polyester(meth)acrylate, or acryl(meth)acrylate, with an active energy ray polymerizable monomer, or only an active energy ray polymerizable monomer may be used.

As the active energy ray polymerizable monomer, photopolymerizable monomers described in «first embodiment» may be used.

### (Active energy ray polymerization initiator)

In the active energy ray-curable resin composition of the present embodiment, no active energy ray polymerization initiator is contained, or even in the case of containing, the content thereof is 2.5% by mass or less.

In the laminate (IV), the active energy ray-curable resin composition which is made in an uncured to semi-cured state is subjected to a dry process so that an unevenness is formed. Therefore, since the curable resin composition is not made to be completely cured at the stage of active energy ray irradiation, as described above, no active energy ray polymerization initiator is contained, or the content thereof may be reduced.

Further, since no active energy ray polymerization initiator is contained or the content is small, the curable resin composition has a low sensitivity to active energy rays, and thus is likely to be kept in an appropriate semi-cured state even when curing is performed by active energy ray irradiation. Then, when the unevenness is formed by the dry process described below, the unevenness can be sufficiently formed, and the shape of the unevenness is also easily controlled. Further, reducing the active energy ray polymerization initiator is also advantageous in terms of cost. Meanwhile, when the content is greater than 2.5% by mass, a polymerization reaction may easily proceed by overcoming the oxygen inhibition that hinders radical polymerization, and curing may excessively proceed by active energy ray irradiation, so that there is a possibility that a desired uneven shape cannot be formed through the dry process.

The content of the active energy ray polymerization initiator in the curable resin composition is preferably 0% by mass or more and 2.0% by mass or less, more preferably 0% by mass or more and 1.5% by mass or less, further preferably 0% by mass or more and 1.0% by mass or less, still further preferably 0% by mass or more and 0.7% by mass or less, from the point that an appropriate semi-cured state is maintained by active energy ray irradiation, making it easier to control the uneven shape, and also in terms of cost.

Further, when in the curable resin composition, the content of the active energy ray polymerization initiator is more than a certain amount, curing appropriately progresses by active energy ray irradiation. Then, the stickiness on the surface of a resin layer (IV) precursor may be suppressed and the handling property is improved. From such a viewpoint, the content of the active energy ray polymerization initiator is further preferably 0.2% by mass or more and 1.0% by mass or less, and from the viewpoint of achieving both the controllability of the uneven shape and the handling property, it is still further preferably 0.2% by mass or more and 0.8% by mass or less.

The content of 0% by mass, which is referred to herein, means that the curable resin composition contains no active energy ray polymerization initiator. Further, the content of the active energy ray polymerization initiator is the content when the curable resin composition is set as 100% by mass.

Examples of the active energy ray polymerization initiator include: benzyl; benzophenone derivatives such as benzophenone, 4-methylbenzophenone, 2-methylbenzophenone, 4,4'-bis(diethylamino)benzophenone, 2,4,6-trimethylbenzophen, and 4-phenylbenzophenone; thioxanthones such as 2-isopropylthioxanthone, 4-isopropylthioxanthone, 2,4-diethylthioxanthone, 2,4-dichlorothioxanthone, 1-chloro-4-propoxythioxanthone, and 2-(3-dimethylamino-2-hydroxy)-3,4-dimethyl-9H-thioxanthone-9-one mesochloride; benzyldimethylketals such as benzyldimethylketal; α-hydroxyalkylphenones such as 2-hydroxy-2-methyl-1-phenylpropane-1-one, 1-hydroxycyclohexyl-phenylketone, 1-[4-(2-hydroxyethoxy)-phenyl]-2-hydroxymethylpropane-1-one, 2-hydroxy-1-{4-[4-(2-hydroxy-2-methylpropionyl)benzyl]phenyl}-2-methyl propane-1-one, and oligo{2-hydroxy-2-methyl-1-[4-(1-methylvinyl)phenyl]propanone}; α-hydroxyacetophenones such as 2-hydroxyacetophenone; hydroxyketones other than these; aminoalkylphenones such as 2-benzyl-2-dimethylamino-4-morpholinobutyrophenone, 2-benzyl-2-dimethylamino-1-(4-morpholinophenyl)-butanone-1,2-methyl-1-[4-(methylthio)phenyl]-2-morpholinopropane-1-one, and 2-(dimethylamino)-2-(4-methylbenzyl)-1-(4-morpholinophenyl)-butane-1-one; acylphosphineoxides such as 2,4,6-trimethylbenzoyldiphenylphosphineoxide, bis(2,6-dimethoxybenzoyl)-2,4,4-trimethylpentylphosphineoxide, and bis(2,4,6-trimethylbenzoyl)-phenylphosphineoxide, and oximeester compounds.

Among them, α-hydroxyalkylphenones are preferable because they hardly cause yellowing during curing, and thus a transparent cured product may be obtained. In particular, 1-hydroxycyclohexyl-phenylketone is preferable.

The active energy ray polymerization initiator may be used alone or in combination of two or more thereof.

If necessary, in a range where the gist of the present invention is not impaired, the curable resin composition may contain an internal defoaming agent, an applicability improver, a thickener, an organic lubricant, a UV absorber, an antioxidant, a foaming agent, a dye, a pigment, inorganic particles, organic particles, and the like. These additives may be used alone, and if necessary, two or more thereof may be used in combination.

### [Thickness of resin layer (IV)]

The thickness (tb) of the resin layer (IV) may be adjusted according to a level difference in an unevenness to be formed or the application, and is not limited, but is preferably 0.1 µm or more and 15 µm or less. When it is 15 µm or less, it is possible to prevent peeling from the base material (IV) due to the internal stress of the resin layer (IV) itself. When the thickness is 0.1 µm or more, the thickness of the resin layer (IV) may be kept uniform, and thus by the unevenness, the roughness of a certain level or higher may be secured. From this point of view, the thickness (tb) of the resin layer (IV) is more preferably 0.5 µm or more, further preferably 1 µm or more, still further preferably 2 µm or more, and also is preferably 10 µm or less, more preferably 7 µm or less.

### <Cover layer (IV) and over cover layer (IV)>

The laminate (IV) may include the cover layer (IV) and the over cover layer (IV). The cover layer (IV) and the over cover layer (IV) are the same as the cover layer (I) and the over cover layer (I) described in «first embodiment».

Further, the layer configuration of the laminate (IV) is the same as described with reference to Figs. 1 to 3 in the first embodiment.

### <Manufacturing method of laminate (IV)>

The laminate (IV) may be manufactured by any manufacturing method, but the same method as the manufacturing method of the laminate (I) described in «first embodiment» is preferable.

That is, the manufacturing method of the laminate (IV) according to a preferred example includes the following steps 1 to 3.
Step 1: a step of applying an active energy ray-curable resin composition on at least one surface of the base material to form a resin layer (IV) precursor
Step 2: a step of semi-curing the resin layer (IV) precursor formed in step 1
Step 3: a step of further performing a surface treatment through a dry process to the resin layer (IV) precursor semi-cured in step 2, so as to form an unevenness on the surface on the one surface side of the base material (IV)

Meanwhile, step 2 may be omitted. Therefore, in step 3, the surface treatment may be carried out to the uncured resin layer (IV) precursor. Further, in step 2 of this manufacturing method, the resin layer (IV) precursor formed in step 1 is irradiated with active energy rays so that the resin layer (IV) precursor is semi-cured. Further, the unevenness formed in step 3 may have a wrinkle structure as described above. Further, in this manufacturing method as well, the following step 4 may be further provided after step 1 to step 3, or step 1 and step 3. Details of each step except the points described above are the same as described in the first embodiment.

### <Application of laminate (IV)>

The application of the laminate (IV) is the same as that of the laminate (I) described in «first embodiment».

### «Fifth embodiment»

As described above, in the laminate of the present invention, a higher-order wrinkle structure may also be formed on the outermost surface.

A laminate according to a fifth embodiment of the present invention (hereinafter, also referred to as a "laminate (V)") includes a base material; and a resin layer provided in this order on at least one surface of the base material. The outermost surface of the laminate on the one surface side of the base material has an unevenness containing a wrinkle structure, and the wrinkle structure includes a primary wrinkle structure, and a secondary wrinkle structure having a smaller undulation period than the primary wrinkle structure.

Hereinafter, the laminate of the present embodiment will be described in more detail. In the following description, the laminate, the base material, the resin layer, a cover layer and an over cover layer in the present embodiment may be referred to as a "laminate (V)", a "base material (V)", a "resin layer (V)", a "cover layer (V)", and an "over cover layer (V)", respectively.

### <Unevenness containing wrinkle structure >

The laminate (V) has an unevenness containing a wrinkle structure, on the outermost surface thereof. A primary wrinkle structure and a secondary wrinkle structure in this wrinkle structure are the same as the primary wrinkle structure and the secondary wrinkle structure described in the laminate (I) of «first embodiment».

The absolute value of Ssk of the outermost surface of the laminate (V) is preferably 5 or less, more preferably 3 or less, further preferably 1 or less, still further preferably 0.8 or less. Further, above all, it is preferably 0.6 or less, more preferably 0.4 or less, further preferably 0.2 or less.

The outermost surface of the laminate (V) preferably has a specific surface area (S/A) of 1.01 or more. The specific surface area set as 1.01 or more means that the surface area is sufficiently increased due to the wrinkle structure. Therefore, in an optical application, cloudiness is also likely to be exhibited, and then it is possible to adjust the haze value of the laminate (V) by adjusting the specific surface area.

From this point of view, the specific surface area (S/A) is more preferably 1.05 or more, further preferably 1.1 or more, still further preferably 1.12 or more.

Further, the specific surface area (S/A) is not particularly limited, but is preferably 2 or less, more preferably 1.7 or less, further preferably 1.5 or less in order to prevent the protrusions of the wrinkle structure from becoming too high and the structural strength from being reduced.

Sa (arithmetic mean roughness) of the outermost surface of the laminate (V) is not particularly limited, but is, for example, 200 nm or more. The Sa set as 200 nm or more means that the unevenness is sufficiently formed by the wrinkle structure, and, for example, in the application to optical materials, it is possible to adjust the cloudiness. From this point of view, the Sa (arithmetic mean roughness) is preferably 300 nm or more, more preferably 400 nm or more, further preferably 500 nm or more, still further preferably 800 nm or more.

Further, the Sa (arithmetic mean roughness) is not particularly limited, but is preferably 5000 nm or less, more preferably 4000 nm or less, further preferably 3000 nm or less from the viewpoint of maintaining the physical strength of the wrinkle structure.

Sz (maximum height) of the outermost surface 10A of the laminate (V) is not particularly limited, but is preferably 3000 nm or more, more preferably 4000 nm or more, further preferably 6000 nm or more. St equal to or higher than these lower limit values means that sufficient buckling has progressed, and a wrinkle structure having high protrusions is formed. Therefore, for example, in the application to optical materials, it is possible to adjust the cloudiness.

The Sz (maximum height) is not particularly limited, but is preferably 30000 nm or less, more preferably 20000 nm or less, further preferably 15000 nm or less from the viewpoint of maintaining the physical strength of the wrinkle structure.

### <Base material (V)>

The base material (V) is the same as the base material (I) described in «first embodiment».

### <Resin layer (V)>

The resin layer (V) is preferably formed of a thermosetting resin composition.

### [Thermosetting resin composition]

The thermosetting resin composition preferably contains a binder resin or a curing agent, more preferably contains both the binder resin and the curing agent. By containing the binder resin and the curing agent, the thermosetting resin composition easily buckles according to the application of the compressive stress while adhesiveness to the base material (V), the cover layer (V), and the like is secured, and therefore, it is easy to form a wrinkle structure.

### (Binder resin)

The binder resin is a thermosetting resin that can be cured through heating, and is a resin cured in the presence of the curing agent when the thermosetting resin composition contains the curing agent.

Examples of the binder resin include polyester resin, urethane resin, acrylic resin, vinyl alcohol resin, ethylenevinyl alcohol resin, vinyl modified resin, oxazoline group-containing resin, carbodiimide group-containing resin, epoxy group-containing resin, isocyanate group-containing resin, alkoxy group-containing resin, modified styrene resin and modified silicon resin. These may be used alone or in combination of two or more thereof. In the binder resin, binder resins may be reacted with each other to form the resin layer (V).

Among these, in terms of the adhesion to the base material (V) or the base material (V) and the cover layer (V), and the hot-water resistance, it is preferable to use at least one selected from polyester resin, urethane resin, acrylic resin, epoxy group-containing resin, and alkoxy group-containing resin alone or a combination of two or more thereof, and acrylic resin is more preferable.

Further, the binder resin may be any resin that is capable of thermally crosslinking such as urethane curing or epoxy curing. From the viewpoint of reactivity with an isocyanate compound suitably used as the curing agent described below, a resin having a hydroxy group, a carboxy group or an amino group is preferable, and a resin having a hydroxy group is more preferable.

Further, above all, polyol having two or more hydroxy groups in one molecule is preferable, and in particular, acrylpolyol is preferable.

As the acrylic resin in the present embodiment, the acrylic resin described in «first embodiment» may be used.

### (Curing agent)

The curing agent is preferably an isocyanate compound from the viewpoint of curability. When the thermosetting resin composition contains the binder resin, a compound that can be cured by reacting with the binder resin may be used.

As the isocyanate compound in the present embodiment, the isocyanate compound described in «first embodiment» may be used.

### (Preferable mode of thermosetting resin composition)

It is preferable that the resin layer (V) contains a resin having a urethane bond and/or a urea bond. When the resin having the urethane bond and/or the urea bond is used, the flexibility is secured, and thus buckling is easily generated by the compressive stress occurring when a surface treatment is carried out by a dry process. Thus, it becomes easy to form the secondary wrinkle structure.

The urethane bond and the urea bond are preferably formed by at least one of a reaction between the binder resins, a reaction of the curing agent, and a reaction between the binder resin and the curing agent, and above these, formation by the reaction between the binder resin and the curing agent is more preferable. When the urethane bond and/or the urea bond are/is formed by such a reaction, it becomes easy to improve the adhesion of the resin layer (V) to the cover layer (V), the base material (V), and the like.

From the viewpoint of promotion of curability with the binder resin, the adhesion of the resin layer (V) to the cover layer (V), the base material (V), or the other, or ease of forming the secondary wrinkle structure, it is preferable to use the isocyanate compound as the curing agent.

When both the binder resin and the curing agent are used for the thermosetting resin composition, it is preferable to use the isocyanate compound as the curing agent, and polyol as the binder resin. When the acrylic resin is used as the binder resin, the acrylic resin is preferably acrylpolyol containing a plurality of hydroxy groups in one molecule as described above.

By adjusting the blending ratio of the binder resin to the curing agent, it is possible to control shapes of the primary and secondary wrinkle structures.

When the isocyanate compound is used as the curing agent, and the polyol is used as the binder resin, the smaller the amount of polyol blended with respect to the isocyanate compound, the longer the fluidity of the thermosetting resin composition during curing is maintained. Thus, it becomes easy to form the secondary wrinkle structure.

From the above viewpoint, R ((the number of isocyanate groups of curing agent)/(the number of hydroxy groups of binder resin)) in the thermosetting resin composition is preferably 2 or more, more preferably 4 or more, further preferably 6 or more.

Further, the thermosetting resin composition may contain no binder resin, that is, the number of hydroxy groups may be 0 (R=oo). R is more preferably 100 or less, further preferably 80 or less, still further preferably 60 or less.

The R in the resin layer (V) can be obtained by combining analysis methods such as NMR, pyrolysis GC/MS, and TOF-SIMS. More specifically, first, an unreacted curing agent is extracted from the cured resin layer (V), and the mother skeleton and the number of isocyanate groups (valence) of the curing agent are specified by the analysis method. Then, the structure of the monomer constituting the binder resin and the number of hydroxy groups (valence) are specified from the cured resin layer (V) by the analysis method. Then, R can be obtained from the ratio of the mother skeleton of the curing agent and the monomers constituting the binder resin and respective valences thereof.

In the thermosetting resin composition, when the isocyanate compound is excessively contained with respect to the polyol (R exceeds 1), the cured resin layer (V) has a urethane bond formed through a reaction between the polyol and the isocyanate compound, and a urea bond formed from the excess isocyanate compound. Therefore, the R can also be obtained from the ratio of the urethane bond and the urea bond of the cured resin layer (V) by using solid NMR, FT-IR, or the like.

If necessary, in a range where the gist of the present invention is not impaired, the thermosetting resin composition may contain an internal defoaming agent, an applicability improver, a thickener, an organic lubricant, a UV absorber, an antioxidant, a foaming agent, a dye, a pigment, inorganic particles, organic particles, and the like. These additives may be used alone, and if necessary, two or more thereof may be used in combination.

### [Thickness of resin layer (V)]

The thickness (tb) of the resin layer (V) may be adjusted according to a level difference in an unevenness to be formed or the application, and is not limited, but is preferably 0.1 µm or more and 15 µm or less. When it is 15 µm or less, it is possible to prevent peeling from the base material (V) due to the internal stress of the resin layer (V) itself. When the thickness is 0.1 µm or more, the thickness of the resin layer (V) may be kept uniform, and thus by a wrinkle structure, the roughness of a certain level or higher may be secured. From this point of view, the thickness (tb) of the resin layer (V) is more preferably 0.5 µm or more, further preferably 1 µm or more, still further preferably 2 µm or more, and also is preferably 10 µm or less, more preferably 7 µm or less.

### <Cover layer (V) and over cover layer (V)>

The laminate (V) may include the cover layer (V) and the over cover layer (V). The cover layer (V) and the over cover layer (V) are the same as the cover layer (I) and the over cover layer (I) described in «first embodiment».

Further, the layer configuration of the laminate (V) is the same as described with reference to Figs. 1 to 3 in the first embodiment.

### <Manufacturing method of laminate (V)>

The laminate (V) may be manufactured by any manufacturing method, but the same method as the manufacturing method of the laminate (I) described in «first embodiment» is preferable.

That is, the manufacturing method of the laminate (V) according to a preferred example includes the following steps 1 to 3.
Step 1: a step of forming a resin layer (V) precursor on at least one surface of the base material
Step 2: a step of semi-curing the resin layer (V) precursor formed in step 1
Step 3: a step of further performing a surface treatment through a dry process to the resin layer (V) precursor semi-cured in step 2, so as to form an unevenness containing an wrinkle structure on the surface on one surface side of the base material (V)

Meanwhile, step 2 may be omitted as described below. Therefore, in step 3, the surface treatment may be carried out on the uncured resin layer (V) precursor.

In step 1, the resin layer (V) precursor is formed of the above-described thermosetting resin composition. For example, the thermosetting resin composition may be coated and formed on at least one surface of the base material (V). Further, in step 2 of this manufacturing method, the resin layer (V) precursor formed in step 1 is semi-cured by heating. Further, in this manufacturing method as well, step 4 may be further provided after step 1 to step 3, or step 1 and step 3. Details of each step except the points described above are the same as described in the first embodiment.

### <Application of laminate (V)>

The application of the laminate (V) is the same as that of the laminate (I) described in «first embodiment».

### <Description of words>

In the present invention, those referred to as a "film" shall include a "sheet", and those referred to as a "sheet" shall include a "film".

### [Example]

Hereinafter, the present invention will be specifically described by Examples. Meanwhile, the present invention is not limited by the following Examples at all.

The measurement method and the evaluation method used in the present invention are as follows.

### (1) Method of measuring thickness of resin layer

The surface of the resin layer was dyed with RuO₄, and embedded in an epoxy resin. Next, a slice which was prepared by an ultramicrotomy method was dyed with RuO₄ again, and then the cross section of the resin layer was measured by using TEM ("H-7650" manufactured by Hitachi High-Tech Corporation, acceleration voltage: 100 kV).

For the thickness, the average value of the maximum thickness and the minimum thickness was used.

### (2) Method of measuring thickness of cover layer, over cover layer or fluorinated layer

A sample was prepared by an epoxy resin-embedding ultramicrotomy method, and measurement was performed by a cross-section TEM device ("JEM-1200 EXII" manufactured by JEOL Ltd.) under a condition of an acceleration voltage of 120 Kv.

### (3) Sa (arithmetic mean roughness), Sz (maximum height), and specific surface area (S/A)

A three-dimensional non-contact surface shape measuring machine (VertScan2.0 R5200G of Ryoka Systems Inc.) was used to measure the Sa, the Sz, and the specific surface area (S/A) of the outermost surface of the laminate. The measurement of Test Examples 1 to 3 and 5 was performed with a 10x objective lens in a range of 496.17 µm×351.89 µm, and the measurement of Test Example 4 was performed with a 50x objective lens in a range of 94.33 µm×70.75 µm.

In the specific surface area (S/A), A represents the area of a measurement target area, S represents the surface area of the measurement target area, and S/A represents the specific surface area of the measurement target area.

### (4) Measurement of degree of deviation

In accordance with ISO25178, the degree of deviation Ssk of the outermost surface in the obtained laminate was measured by the method described in the specification.

### (5) Surface observation

In Test Examples 1 to 3 and 5, the outermost surface of the laminate on the one surface side of the base material was photographed at 5000x and 50000x by using a scanning microscope to obtain an observation image of 60 µm×40 µm, and an observation image of 6 µm×4 µm. The case where an irregular wrinkle-like unevenness (wrinkle-structure unevenness) was observed in any of the observation images was evaluated as A (good), and the case where no wrinkle-structure unevenness was observed in any of the observation images was evaluated as B (poor).

Further, regarding the presence or absence of a higher-order wrinkle structure, the case where a wrinkle-structure unevenness was observed in both the 60 µm×40 µm observation image and the 6 µm × 4 µm observation image was evaluated as A, and the case where no wrinkle-structure unevenness was observed in either one or both of the observation images was evaluated as B. Furthermore, in an 5.2 mm × 6.9 mm observation image as well, which was observed at 1x by using a stereoscopic microscope (LEICAS9i of Leica Microsystems), the case where a wrinkle-structure unevenness was observed was evaluated as S.

In Test Example 4, the outermost surface of the laminate on one surface side of the base material was observed with a 50x objective lens by using the three-dimensional non-contact surface shape measuring machine, and a three-dimensional observation image of 94.33 µm × 70.75 µm was obtained. The case where an irregular wrinkle-like unevenness (wrinkle-structure unevenness) was observed in each observation image was evaluated as A (good), and the case where no wrinkle-structure unevenness was observed in any of observation images was evaluated as B (poor).

### (6) Carbon content and oxygen content of inorganic substance-containing layer

For the laminate of Test Example 2, the bond energy was measured through XPS (X-ray photoelectron spectroscopy) by using an XPS analysis device ("K-Alpha" manufactured by Thermo Fisher Scientific Inc.), and the element composition (at.%) was calculated through conversion from the areas of peaks corresponding to Si2P, C1S, N1S, O1S, and the like.

### (7) Contact angle

For the laminates of Test Examples 2 and 3, the contact angle with respect to the water droplet was measured by using a contact angle meter ("DropMaster 500" manufactured by Kyowa Interface Science Co., Ltd.).

### (8) Haze value

The haze value (%) of the laminate in Test Example 4 was measured by a haze meter ("NDH5000" manufactured by NIPPON DENSHOKU INDUSTRIES Co., Ltd.) in accordance with JISK7136:2000.

### <Test Example 1: Examples 1 to 17 and Comparative Examples 1 to 3>

In Test Example 1, laminates of Examples 1 to 17 and Comparative Examples 1 to 3 were prepared, and the wrinkle structure on the surface was evaluated.

### Example 1

### (Preparation of thermosetting resin composition (AC1))

2.00 parts by mass of acrylpolyol (product name: "UV-G301" manufactured by NIPPON SHOKUBAI CO., LTD.) as a binder resin, 2.46 parts by mass of an isocyanate-based compound (product name: "TAKENATE D-165N", a hexamethylenediisocyanate-based compound manufactured by Mitsui Chemicals, Inc.) as a curing agent, and 10.70 parts by mass of ethyl acetate as a solvent were mixed, and thereby, a diluted solution of a thermosetting resin composition (AC1) having a solid content concentration of 21.83% by mass was prepared.

### (Formation of resin layer precursor)

The obtained diluted solution of the thermosetting resin composition (AC1) was applied to one surface of a PET film (product name "T100 type" manufactured by Mitsubishi Chemical Corporation, thickness: 188 µm) as a base material such that the thickness after curing was as noted in Table 1, and then was dried and cured by being heated at 80°C for 1 min, and thereby, a semi-cured resin layer precursor was formed. Next, immediately after it was left at room temperature (23°C) for 3 h, the CVD processing described below was started.

### (Formation of cover layer)

By using a plasma CVD device (manufactured by U-Tech Co., Ltd.), an acetylene gas was introduced, the partial pressure was set as 1 Pa, and CVD was performed with power of 500 W under a vacuum of 1 Pa, so that an inorganic substance-containing layer (1) (DLC layer) with a thickness of 90 nm was formed on the semi-cured resin layer precursor and a laminate having a stacked structure of base material/resin layer/cover layer was obtained.

### (Surface observation)

Figs. 6 and 7 illustrate images obtained by photographing the outermost surface of the laminate of Example 1, at 5000x and 50000x. As illustrated in Figs. 6 and 7, in each observation image, irregular protrusions appeared and a wrinkle structure was observed. Further, since wrinkle structures were observed in both observation images having a magnification ratio of 10 times, it can be understood that the unevenness appearing on the outermost surface had primary and secondary wrinkle structures.

### Examples 2 to 5

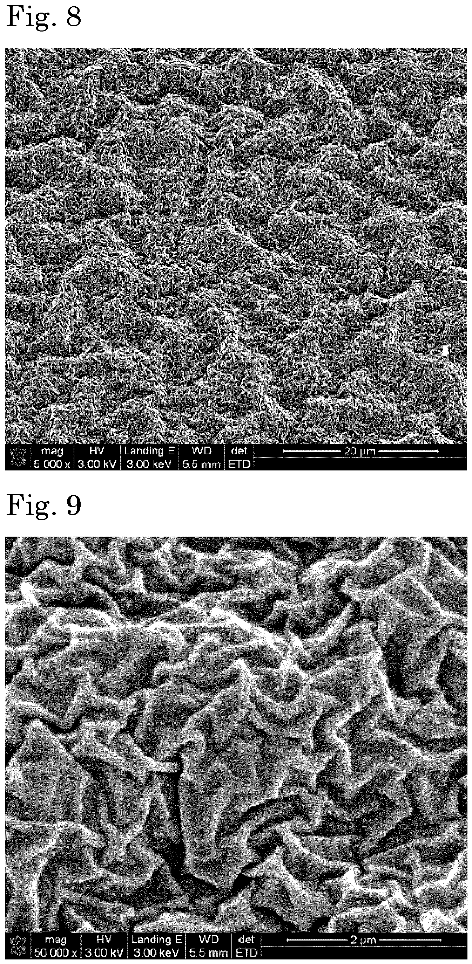

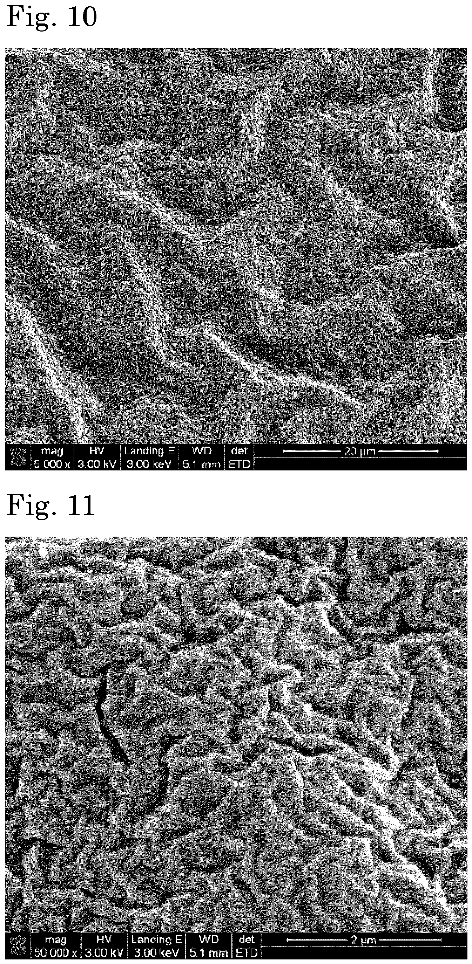

These were carried out in the same manner as in Example 1 except that the thickness of the resin layer was changed as noted in Table 1. Representatively, the 5000x and 50000x observation images in Example 3 are illustrated in Figs. 8 and 9, and the 5000x and 50000x observation images in Example 5 are illustrated in Figs. 10 and 11.

### Example 6

This was carried out in the same manner as in Example 4 except that after the cover layer was formed, an over cover layer was formed on the cover layer through the method described below. Then, a laminate having a stacked structure of base material/resin layer/cover layer/over cover layer was obtained.

### (Formation of over cover layer)

By using a plasma CVD device (manufactured by SHINKO SEIKI CO., LTD.), tetramethylsilane was introduced as a raw material gas at 20 sccm, and argon was further introduced at 50 sccm, and CVD was performed with power of 500 W under a reduced pressure of 0.15 Pa to form a silicon carbide (SiC) layer with a thickness of 20 nm on the cover layer.

### Examples 7 and 8

These were carried out in the same manner as in Example 4 except that the DLC layer was formed such that the thickness of the inorganic substance-containing layer (1) (DLC layer) was as noted in Table 1.

### Example 9

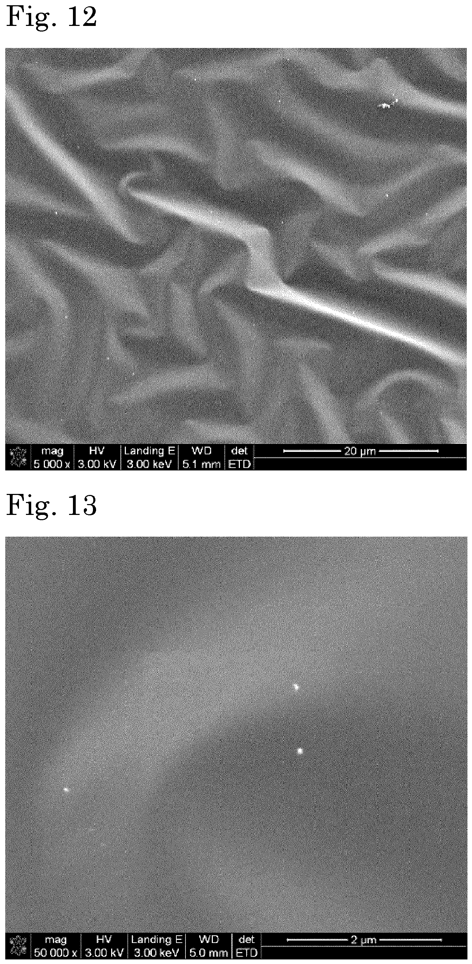

This was carried out in the same manner as in Example 4 except that the formation of the cover layer was performed by the following method so that a niobium oxide (NbOₓ) layer was obtained as the cover layer. Figs. 12 and 13 illustrate 5000x and 50000x observation images of the outermost surface of the laminate on one surface side of the base material.

### (Formation of cover layer)

Niobium was used as a target material, and argon of 4 sccm and oxygen of 6 sccm were introduced, and reactivity sputtering was performed by using a sputtering device (manufactured by Eicoh Co., Ltd.) under a reduced pressure of 0.8 Pa under a condition of power of 100 W, so that the inorganic substance-containing layer (1) (niobium oxide layer) with a thickness of 90 nm was formed on the semi-cured resin layer precursor.

### Example 10

### (Preparation of active energy ray-curable resin composition (AC2))

99.5 parts by mass of fluorene-based bifunctional acrylate (manufactured by Osaka Gas Chemicals Co., Ltd., product name "OGSOL EA-0250P") as a photopolymerizable compound, and 0.5 parts by mass of a photopolymerization initiator (IGM Resins B.V., product name "Omnirad184", 1-hydroxycyclohexyl-phenylketone) were added to and dissolved in methylisobutylketone (MIBK) as a solvent such that the solid content concentration became 10% by mass, and thereby, a diluted solution of an active energy ray-curable resin composition was obtained.

### (Formation of semi-cured resin layer precursor)

The obtained diluted solution of the active energy ray-curable resin composition (AC2) was applied to one surface of a PET film (manufactured by Mitsubishi Chemical Corporation, product name "T100 type", thickness 188 µm) as a base material such that the thickness after drying was as noted in Table 1, and then was dried by being heated at 80°C for 1 min. Next, a UV ray irradiation device (manufactured by Ushio Inc.) was used to perform irradiation of UV rays from a high-pressure mercury lamp with a cumulative light amount of 427 mJ/cm², so that curing progressed and a semi-cured resin layer precursor was formed. Thereafter, it was left at room temperature (23°C) for 3 h, and then the CVD processing described below was started.

### (Formation of cover layer)

Next, a cover layer was formed in the same manner as in Example 1 except that the DLC layer was formed such that the thickness of the inorganic substance-containing layer (1) (DLC layer) was as noted in Table 1.

### Example 11

This was carried out in the same manner as in Example 10 except that the formation of the cover layer was performed by the following method so that a silicon oxide (SiOₓ) layer was obtained as the cover layer.

### (Formation of cover layer)

By using a vacuum vapor deposition device (manufactured by ULVAC, Inc.), vacuum vapor deposition was performed with silicon oxide as a vapor deposition source, so that the inorganic substance-containing layer (1) (silicon oxide layer) was formed with a thickness of 50 nm on the semi-cured resin layer precursor.

### Example 12

This was carried out in the same manner as in Example 6 to obtain a laminate except that a PET bottle (PET wide mouth bottle manufactured by Nihon Medical Science, Inc., capacity 100 ml, side wall surface thickness 800 µm) was used as the base material, the diluted solution of the thermosetting resin composition (AC1) was applied to the inner surface (one surface) of the side wall surface of the PET bottle to form the semi-cured resin layer precursor, and the thickness of the silicon carbide layer (over cover layer) was changed as noted in Table 2.

### Example 13

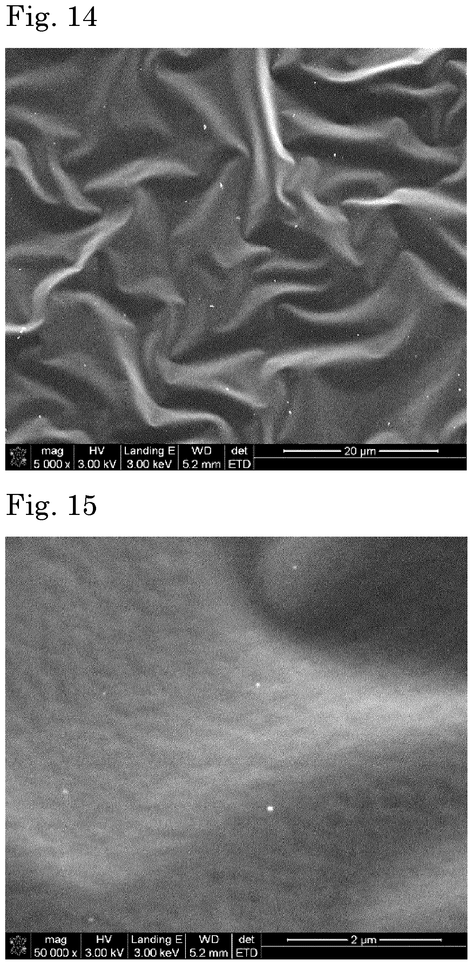

This was carried out in the same manner as in Example 4 to obtain a laminate having a stacked structure of base material/resin layer except that plasma treatment was performed to the surface of the semi-cured resin layer precursor with power of 500 W by using only argon gas (100 sccm) in a plasma CVD device (manufactured by U-Tech Co., Ltd.), instead of forming the cover layer on the semi-cured resin layer precursor. Figs. 14, and 15 illustrate 5000x and 50000x observation images of the outermost surface of the laminate on the one surface side of the base material.

### Example 14

This was carried out in the same manner as in Example 4 except that a glass plate (manufactured by Matsunami Glass Ind., Ltd., product name "white slide glass", thickness 800 µm) was used as the base material, and thereby, a laminate in which the resin layer, and the DLC layer were provided in this order on the one surface of the glass plate was obtained.

### Example 15

This was carried out in the same manner as in Example 4 except that an aluminum plate (product name "AlumiPlate", thickness 800 µm) was used as the base material, and thereby, a laminate in which the resin layer, and the DLC layer were provided in this order on the one surface of the aluminum plate was obtained.

### Example 16

This was carried out in the same manner as in Example 4 except that the formation of the cover layer was performed by the following method so that a fluorine-based resin layer was obtained as the cover layer.

### (Formation of cover layer)

By using a plasma CVD device (manufactured by SHINKO SEIKI CO., LTD.) perfluoroethylene was introduced at 10 sccm as a fluorine-based resin component, and CVD was performed under a vacuum of 5 Pa, so that the cover resin layer (1) (fluorine-based resin layer) was formed with a thickness of 10 nm on the semi-cured resin layer precursor.

### Example 17

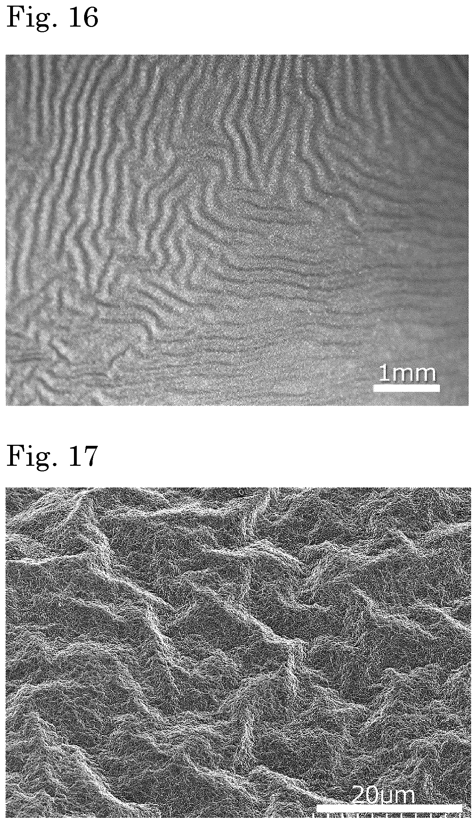

This was carried out in the same manner as in Example 12 except that the formation of the over cover layer was performed by the following method so that a fluorine-based resin (C₃F₈) layer was obtained as the over cover layer. Figs. 16 to 18 illustrate 1x, 5000x and 50000x observation images of the outermost surface of the laminate on the one surface side of the base material.

### (Formation of over cover layer)

By using a plasma CVD device (SHINKO SEIKI CO., LTD.), octafluoropropane (C₃F₈) was introduced at 10 sccm, and CVD was performed under a vacuum of 5 Pa so as to form a fluorine-based resin (C₃F₈) layer with a thickness of 10 nm on the cover layer.

### Comparative Example 1

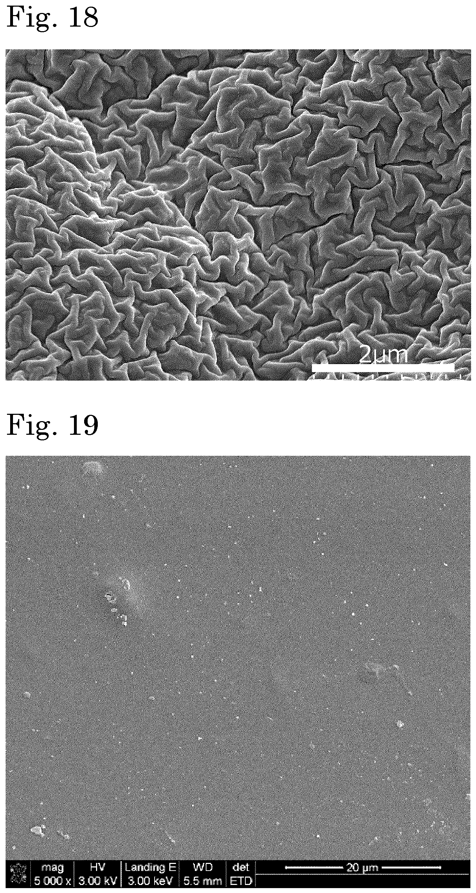

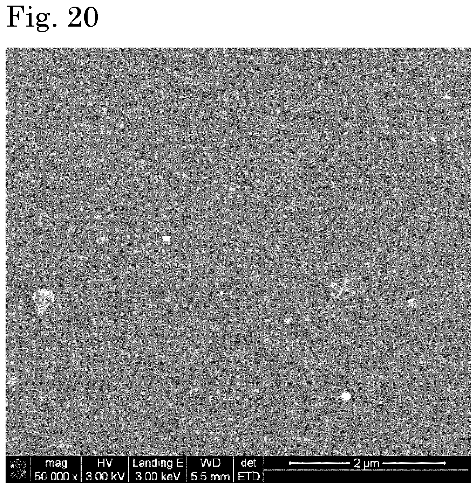

A single base material composed of a PET film (manufactured by Mitsubishi Chemical Corporation, product name "T100 type", thickness 188 µm) was used as a laminate of Comparative Example 1. Figs. 19 and 20 illustrate 5000x and 50000x observation images of the PET film surface.

### Comparative Example 2

This was carried out in the same manner as in Example 1 except that the formation of the semi-cured resin layer precursor was omitted, and a laminate having a stacked structure of base material/cover layer was obtained.

### Comparative Example 3

This was carried out in the same manner as in Example 4 except that the formation of the cover layer was omitted, and a laminate having a stacked structure of base material/resin layer was obtained.

**Table 1**

| | | | Example 1 | Example 2 | Example 3 | Example 4 | Example 5 | Example 6 | Example 7 | Example 8 | Example 9 | Example 10 |
|---|---|---|---|---|---|---|---|---|---|---|---|---|
| Over cover layer | Film forming method | - | | | | | | CVD | | | | |
| | Type | - | | | | | | SiC | | | | |
| | Thickness | nm | | | | | | 20 | | | | |
| Cover layer | Film forming method | - | CVD | CVD | CVD | CVD | CVD | CVD | CVD | CVD | Sputter | CVD |
| | Type | | DLC | DLC | DLC | DLC | DLC | DLC | DLC | DLC | NbOx | DLC |
| | Thickness(tₐ) | nm | 90 | 90 | 90 | 90 | 90 | 90 | 30 | 180 | 90 | 100 |
| Resin layer | Type | - | AC1 | AC1 | AC1 | AC1 | AC1 | AC1 | AC1 | AC1 | AC1 | AC2 |
| | Thickness(t_{b}) | µm | 0.5 | 1 | 3 | 5 | 10 | 5 | 5 | 5 | 5 | 2 |
| Base material | Type | - | PET sheet | PET sheet | PET sheet | PET sheet | PET sheet | PET sheet | PET sheet | PET sheet | PET sheet | PET sheet |
| | Thickness | µm | 188 | 188 | 188 | 188 | 188 | 188 | 188 | 188 | 188 | 188 |
| Surface roughness | Sa | nm | 53 | 304 | 750 | 978 | 1059 | 1037 | 697 | 856 | 345 | 243 |
| | Sz | nm | 4397 | 5143 | 6313 | 7539 | 8891 | 8915 | 8106 | 9380 | 6609 | 6884 |
| Thickness ratio(t_{a/}t_{b}) | | - | 180 | 90 | 30 | 18 | 9 | 18 | 6 | 36 | 18 | 50 |
| Unevenness having wrinkle structure | | - | A | A | A | A | A | A | A | A | A | A |
| Presence or absence of higher-order wrinkle structure | | - | A | - | A | - | A | - | - | - | B | - |
| Specific surface area | S/A | - | 1.0091 | 1.0795 | 1.1392 | 1.1526 | 1.1458 | 1.1638 | 1.1231 | 1.1139 | 1.2596 | 1.3095 |
| Degree of deviation | Ssk | - | 0.6362 | 0.2036 | 0.0418 | -0.0150 | 0.0412 | 0.0309 | -0.0417 | -0.0017 | -0.1164 | 0.0617 |

**Table 2**

| | | | Example 11 | Example 12 | Example 13 | Example 14 | Example 15 | Example 16 | Example 17 | Comparative Example 1 | Comparative Example 2 | Comparative Example 3 |
|---|---|---|---|---|---|---|---|---|---|---|---|---|
| Over cover layer | Film forming method | - | - | CVD | - | - | - | - | CVD | - | - | - |
| | Type | - | - | SiC | - | - | - | - | C3F8 | - | - | - |
| | Thickness | nm | - | 140 | - | - | - | - | 10 | - | - | - |
| Cover layer | Film forming method | - | Vacuum vapor deposition | CVD | (Plasma) | CVD | CVD | CVD | CVD | - | CVD | - |
| | Type | - | SiOx | DLC | None | DLC | DLC | Fluorine-based resin | DLC | - | DLC | - |
| | Thickness(tₐ) | nm | 50 | 90 | 0 | 90 | 90 | 10 | 90 | - | 90 | - |
| Resin layer | Type | - | AC2 | AC1 | AC1 | AC1 | AC1 | AC1 | AC1 | - | - | AC1 |
| | Thickness(t_{b}) | µm | 2 | 5 | 5 | 5 | 5 | 5 | 5 | - | - | 5 |
| Base material | Type | - | PET sheet | PET bottle | PET sheet | Glass plate | Al plate | PET sheet | PET bottle | PET sheet | PET sheet | PET sheet |
| | Thickness | µm | 188 | 800 | 188 | 800 | 500 | 188 | 800 | 188 | 188 | 188 |
| Surface roughness | Sa | nm | 125 | 1195 | 357 | 840 | 903 | 263 | 1583 | 24 | 27 | 2 |
| | Sz | nm | 6012 | 6977 | 6509 | 7289 | 7387 | 5356 | 12155 | 4617 | 3453 | 33 |
| Thickness ratio(t_{a/}t_{b}) | | - | 25 | 18 | 0 | 18 | 18 | 2 | 18 | - | - | - |
| Unevenness having wrinkle structure | | - | A | A | A | A | A | A | A | B | B | B |
| Presence or absence of higher-order wrinkle structure | | - | - | - | B | - | - | - | S | B | - | - |
| Specific surface area | S/A | - | 1.0105 | 1.0469 | 1.1430 | 1.1160 | 1.1110 | 1.0679 | 1.1213 | 1.0013 | 1.0008 | 1.0000 |
| Degree of deviation | Ssk | - | 0.1190 | 0.1270 | 0.1923 | -0.0759 | -0.0616 | 0.2132 | -0.0425 | -5.3713 | 7.7311 | 0.9450 |

As noted in Tables 1 and 2, in each Example, it was possible to form the unevenness containing the wrinkle structure, on the outermost surface of the laminate, by subjecting the semi-cured resin layer precursor to the surface treatment by the dry process. From Example 1 to Example 5, it can be found that it is possible to easily control an unevenness level difference by changing the thickness of the resin layer. Further, for example, from Example 3 and Example 9, it can be found that it is possible to separately produce a simple wrinkle structure and a complicated wrinkle structure (collective formation of the primary wrinkle structure and the secondary wrinkle) by changing the dry process treatment. Further, from Example 12 and Example 17, it can be found that an application to a three-dimensional shape such as a container inner surface is also possible. Thus, it is possible to form an optimum unevenness structure for various applications (adhesion prevention, light transmission, etc.) in which the fine unevenness on the surface is utilized.

On the other hand, the laminate of each Comparative Example did not have the unevenness containing the wrinkle structure, on the outermost surface.

### <Test Example 2: Examples 18 to 20 and Comparative Examples 1 and 3>

In Test Example 2, regarding the laminate of Examples 18 to 20 in which the cover layer was the inorganic substance-containing layer, the wrinkle structure and water-repellency on the surface were confirmed, and were compared to those in Comparative Examples 1 and 3.

### Example 18

### (Formation of resin layer precursor)

The diluted solution of the thermosetting resin composition (AC1), which is the same as in Test Example 1, was applied to one surface of a PET film (manufactured by Mitsubishi Chemical Corporation, product name "T100 type", thickness 188 µm) as a base material such that the thickness after curing was as noted in Table 3, and then was dried and cured by being heated at 80°C for 1 min, and thereby, a semi-cured resin layer precursor was formed. Next, immediately after it was left at room temperature (23°C) for 3 h, the CVD processing described below was started.

### (Formation of cover layer)

By using a plasma CVD device (manufactured by Shimadzu Corporation), hexamethyldisiloxane (HMDSO) was introduced at 60 sccm as a raw material gas, and CVD was performed under a pressure of 0.5 Pa under the condition of discharge output of 500 W, so that an inorganic substance-containing layer (SiOₓC_{y} layer, x=1.2, y=2.0) with a thickness of 23 nm was formed as the cover layer on the semi-cured resin layer precursor, and a laminate was obtained.

### Example 19

This was carried out in the same manner as in Example 18 except that the inorganic substance-containing layer (SiOₓC_{y} layer, x=1.2, y=2.0), as the cover layer, was formed with a thickness of 42 nm.

### Example 20

### (Formation of resin layer precursor)

A PET bottle (PET wide mouth bottle manufactured by Nihon Medical Science, Inc., capacity 100 ml, side wall surface thickness 800 µm) was used as the base material, and the diluted solution of the thermosetting resin composition (AC1) was applied to the inner surface (one surface) of the side wall surface of the PET bottle, and then was dried and cured by being heated at 80°C for 1 min, so that a semi-cured resin layer precursor was formed. Next, immediately after it was left at room temperature (23°C) for 3 h, the CVD processing described below was started.

### (Formation of cover layer)

By using a plasma CVD device (manufactured by SHINKO SEIKI CO., LTD.), tetramethylsilane was introduced at 20 sccm as a raw material gas, and argon was further introduced at 50 sccm, and CVD was performed under a reduced pressure of 0.15 Pa, so that a silicon carbide (SiC) layer with a thickness of 140 nm was formed as the cover layer on the semi-cured resin layer precursor, and a laminate was obtained.

### Comparative Examples 1 and 3

The same laminates as those of Test Example 1 were used in Comparative Examples 1 and 3.

**Table 3**

| | | | Example 18 | Example 19 | Example 20 | Comparative Example 1 | Comparative Example 3 |
|---|---|---|---|---|---|---|---|
| Cover layer | Film forming method | - | CVD | CVD | CVD | - | - |
| | Type | | SiOxCy | SiOxCy | SiC | | |
| | x | | 1.2 | 1.2 | | | |
| | y | - | 2.0 | 2.0 | - | - | - |
| | Thickness(tₐ) | nm | 23 | 42 | 140 | - | - |
| Resin layer | Type | - | AC1 | AC1 | AC1 | - | AC1 |
| | Thickness(t_{b}) | µm | 5 | 5 | 5 | - | 5 |
| Base material | Type | - | PET sheet | PET sheet | PET bottle | PET sheet | PET sheet |
| | Thickness | µm | 188 | 188 | 800 | 188 | 188 |
| Surface roughness | Sa | nm | 896 | 989 | 326 | 24 | 2 |
| | Sz | nm | 6799 | 6177 | 3268 | 4617 | 33 |
| Thickness ratio(t_{a/}t_{b}) | | - | 4.6 | 8.4 | 28 | - | - |
| Unevenness having wrinkle structure | | - | A | A | A | B | B |
| Contact angle | | ° | 112 | 103 | 106 | 66 | 78 |
| Specific surface area | S/A | - | 1.0515 | 1.0532 | 1.0779 | 1.0013 | 1.0000 |
| Degree of deviation | Ssk | - | 0.1291 | 0.0280 | -0.0042 | -5.3713 | 0.9450 |

As noted in Table 3, in each Example, it was possible to increase both the surface roughness (Sa, Sz) and the specific surface area of the outermost surface of the laminate by forming the cover layer (inorganic substance-containing layer) on the semi-cured resin layer precursor through the dry process. Together with providing the inorganic substance-containing layer formed of the silicon-based compound, the contact angle with respect to water was accordingly increased, and thus a good liquid repellency was obtained.

On the other hand, in Comparative Example, the cover layer (inorganic substance-containing layer) was not formed, and also both the surface roughness (Sa, Sz) and the specific surface area of the outermost surface of the laminate were small. Thus, the contact angle with respect to water remained small, and it was not possible to obtain a good liquid repellency.

### <Test Example 3: Examples 17, and 21 to 24, Comparative Examples 1, 2, and 4, and Reference Example 1>

In Test Example 3, regarding the laminate of Example 17, and Examples 21 to 24, as the laminate having the fluorine-based compound on the surface of the cover layer, the wrinkle structure and water-repellency on the surface were confirmed, and were compared to those in Comparative Examples 1, 2, and 4 and Reference Example 1.

### Example 17

The same laminate as that in Test Example 1 was used in Example 17.

### Example 21

### (Formation of resin layer precursor)

The diluted solution of the thermosetting resin composition (AC1), which is the same as in Test Example 1, was applied to one surface of a PET film (manufactured by Mitsubishi Chemical Corporation, product name "T100 type", thickness 188 µm) as a base material such that the thickness on the laminate was as noted in Table 4, and then was dried and cured by being heated at 80°C for 1 min, so that a semi-cured resin layer precursor was formed. Next, immediately after it was left at room temperature (23°C) for 3 h, the CVD processing described below was started.

### (Formation of cover layer)

By using a plasma CVD device (manufactured by U-Tech Co., Ltd.), an acetylene gas was introduced, the partial pressure was set as 1 Pa, and CVD was performed with power of 500 W under a vacuum of 1 Pa, so that an inorganic substance-containing layer (DLC layer) with a thickness of 90 nm was formed as a cover layer on the semi-cured resin layer precursor.

### (Fluorination Treatment)

Vacuum vapor deposition was performed with a film thickness of 10 nm by using a silane coupling agent (manufactured by Canon Optron, Inc., product name "SURFCLEAR100". Hereinafter, also referred to as "SC"), which is trimethoxysilane having a perfluoroalkylether group, so that the surface of the cover layer was fluorinated, and a fluorine-based compound was contained in the surface of the cover layer. Accordingly, a laminate having a stacked structure of base material/resin layer/cover layer and having the fluorine-based compound on the surface of the cover layer was obtained.

### Examples 22 and 23

These were carried out in the same manner as in Example 21 except that the resin layer was formed such that the thickness in the obtained laminate was as noted in Table 4.

### Example 24

Similarly to Example 23, after the resin layer, and the cover layer were formed on the base material, the following fluorination treatment was performed to form a fluorine-based compound layer. Accordingly, a laminate having a stacked structure of base material/resin layer/cover layer/fluorine-based compound layer was obtained.

### (Fluorination Treatment)

By using a plasma CVD device (SHINKO SEIKI CO., LTD.), octafluoropropane (C₃F₈) was introduced at 10 sccm, and CVD was performed under a vacuum of 5 Pa, so that the fluorine-based compound layer (fluorine-based resin layer) with a thickness of 10 nm was formed on the cover layer.

### Comparative Examples 1 and 2

The same laminates as those of Test Example 1 were used in Comparative Examples 1 and 2.

### Comparative Example 4

This was carried out in the same manner as in Example 24 except that the formation of the resin layer precursor and the cover layer was omitted, and then a laminate having a stacked structure of base material/fluorine-based resin layer was obtained.

### Reference Example 1

A single base material composed of a Teflon (registered trademark) plate (PTFE plate, manufactured by AS ONE Corporation, product name "3-3282-01", thickness 1000 µm) was used as a laminate of Reference Example 1.

**Table 4**

| | | | Example 17 | Example 21 | Example 22 | Example 23 | Example 24 | Comparative Example 1 | Comparative Example 2 | Comparative Example 4 | Reference Example 1 |
|---|---|---|---|---|---|---|---|---|---|---|---|
| Fluorination Treatment | Film forming method | - | CVD | Vapor deposition | Vapor deposition | Vapor deposition | CVD | - | - | CVD | - |
| | Type | - | C3F8 | SC | SC | SC | C3F8 | - | | C3F8 | - |
| | Thickness | nm | 10 | 10 | 10 | 10 | 10 | - | | 10 | - |
| Cover layer | Film forming method | - | CVD | CVD | CVD | CVD | CVD | - | CVD | - | - |
| | Type | - | DLC | DLC | DLC | DLC | DLC | - | DLC | - | - |
| | Thickness(tₐ) | nm | 90 | 90 | 90 | 90 | 90 | - | 90 | - | - |
| Resin layer | Type | - | AC1 | AC1 | AC1 | AC1 | AC1 | - | - | - | - |
| | Thickness(t_{b}) | µm | 5 | 0.5 | 1 | 5 | 5 | - | - | - | - |
| Base material | Type | - | PET bottle | PET sheet | PET sheet | PET sheet | PET sheet | PET sheet | PET sheet | PET sheet | Teflon plate |
| | Thickness | µm | 800 | 188 | 188 | 188 | 188 | 188 | 188 | 188 | 1000 |
| Surface roughness | Sa | nm | 1583 | 184 | 351 | 1330 | 1316 | 24 | 27 | 28 | 181 |
| | Sz | nm | 12155 | 5657 | 4773 | 9851 | 11347 | 4617 | 3453 | 3796 | 2450 |
| Thickness ratio(t_{a/}t_{b}) | | - | 18 | 180 | 90 | 18 | 18 | - | - | - | - |
| Unevenness having wrinkle structure | | - | A | A | A | A | A | B | B | B | B |
| Contact angle | | ° | 133 | 128 | 130 | 135 | 131 | 66 | 72 | 110 | 112 |
| Specific surface area | S/A | - | 1.1213 | 1.0486 | 1.0722 | 1.1770 | 1.1871 | 1.0013 | 1.0008 | 1.0011 | 1.0029 |
| Degree of deviation | Ssk | - | -0.0425 | -0.0479 | 0.0550 | 0.2122 | -0.0737 | -5.3713 | 7.7311 | -2.6784 | -0.1538 |

As noted in Table 4, in each Example, it was possible to form the unevenness containing the wrinkle structure on the outermost surface of the laminate and thus to increase both the surface roughness (Sa, Sz) and the specific surface area by forming the cover layer on the resin layer precursor through the dry process. Together with containing the fluorine-based compound on the surface of the cover layer, the contact angle with respect to water was accordingly increased, and thus it was possible to exhibit a good liquid repellency.

On the other hand, in Comparative Examples 1 and 2, the resin layer was not provided or the unevenness was not formed through the dry process. Thus, the unevenness containing the wrinkle structure could not be formed on the outermost surface of the laminate, and it was not possible to increase both the surface roughness (Sa, Sz) and the specific surface area. Therefore, the contact angle with respect to water was small, and thus it was not possible to obtain a good liquid repellency.

In Comparative Example 4, although the fluorine-based compound was contained in the outermost surface of the laminate, the unevenness containing the wrinkle structure was not included, and thus, the contact angle with respect to water was small as compared to in Examples 17, and 21 to 24.

Further, from Reference Example 1, it was confirmed that the laminate of Examples 17, and 21 to 24 had a larger contact angle with respect to water than a general Teflon plate.

### <Test Example 4: Examples 25 to 28 and Comparative Examples 1 and 5>

In Test Example 4, regarding the laminates of Examples 25 to 28, the wrinkle structure and the haze on the surface were confirmed, and were compared to those in Comparative Examples 1 and 5.

### Example 25

### (Formation of resin layer precursor)

The diluted solution of the active energy ray-curable resin composition (AC2), which was the same as in Test Example 1, was applied to one surface of a PET film (manufactured by Mitsubishi Chemical Corporation, product name "T100 type", thickness 188 µm) as a base material such that the thickness after drying was as noted in Table 5, and then was dried by being heated at 80°C for 1 min. Next, a UV ray irradiation device (manufactured by Ushio Inc.) was used to perform irradiation of UV rays from a high-pressure mercury lamp with a cumulative light amount of 427 mJ/cm², so that curing progressed and a semi-cured resin layer precursor was formed. The stickiness on the surface of the semi-cured resin layer precursor was slight. Then, immediately after it was left at room temperature (23°C) for 3 h, the vacuum vapor deposition described below was started.

### (Formation of cover layer)

By using a vacuum vapor deposition device (manufactured by ULVAC, Inc.), vacuum vapor deposition was performed with silicon oxide as a vapor deposition source, so that an inorganic substance-containing layer (1) (silicon oxide (SiOx) layer) was formed with a thickness of 50 nm on the semi-cured resin layer precursor and laminate having a stacked structure of base material/resin layer/cover layer was obtained.

### Example 26

This was carried out in the same manner as in Example 1 except that the formation of the cover layer was performed by the following method so that a DLC layer was obtained as the cover layer.

### (Formation of cover layer)

By using a plasma CVD device (manufactured by U-Tech Co., Ltd.), an acetylene gas was introduced, the partial pressure was set as 1 Pa, and CVD was performed with power of 500 W under a vacuum of 1 Pa, and thereby, the inorganic substance-containing layer (1) (DLC layer) was formed with a thickness of 100 nm on the semi-cured resin layer precursor and a laminate having a stacked structure of base material/resin layer/cover layer was obtained.

### Examples 27 and 28

### (Preparation of active energy ray-curable resin composition (AC3))

Fluorene-based bifunctional acrylate (manufactured by Osaka Gas Chemicals Co., Ltd., product name "OGSOL EA-0250P") as a photopolymerizable compound was added to and dissolved in methylisobutylketone (MIBK) as a solvent such that the solid content concentration became 10% by mass, and thereby, a diluted solution of an active energy ray-curable resin composition (AC3) was obtained.

These were carried out in the same manner as in Examples 25 and 26 except that the active energy ray-curable resin composition (A3) was used. The surface of the semi-cured resin layer precursor was somewhat sticky.

### Comparative Example 1

The same laminate as that in Test Example 1 was used in Comparative Example 1.

### Comparative Example 5

This was carried out in the same manner as in Example 25 to obtain a laminate having a stacked structure of base material/cover layer except that the formation of the resin layer precursor was omitted.

**Table 5**

| | | | Example 25 | Example 26 | Example 27 | Example 28 | Comparative Example 1 | Comparative Example 5 |
|---|---|---|---|---|---|---|---|---|
| Cover layer | Film forming method | - | Vacuum vapor deposition | CVD | Vacuum vapor deposition | CVD | - | Vacuum vapor deposition |
| | Type | - | SiOx | DLC | SiOx | DLC | - | SiOx |
| | Thickness(tₐ) | nm | 50 | 100 | 50 | 100 | - | 50 |
| Resin layer | Type | - | AC2 | AC2 | AC3 | AC3 | - | - |
| | Amount of polymerization initiator | % by mass | 0.5 | 0.5 | 0 | 0 | - | - |
| | Thickness(t_{b}) | µm | 2 | 2 | 2 | 2 | - | - |
| Base material | Type | - | PET sheet | PET sheet | PET sheet | PET sheet | PET sheet | PET sheet |
| | Thickness | µm | 188 | 188 | 188 | 188 | 188 | 188 |
| Surface roughness | Sa | nm | 84 | 248 | 157 | 533 | 24 | 3 |
| | Sz | nm | 549 | 2440 | 815 | 4223 | 4617.0 | 1099 |
| Thickness ratio(t_{a/}t_{b}) | | - | 25 | 50 | 25 | 50 | - | - |
| Unevenness having wrinkle structure | | - | A | A | A | A | B | B |
| Haze | | % | 33.8 | 91.2 | 53.9 | 92.1 | - | 1.1 |
| Specific surface area | S/A | - | 1.0031 | 1.3097 | 1.0136 | 1.3007 | 1.0013 | 1.0013 |
| Degree of deviation | Ssk | - | 0.0895 | 0.0614 | 0.0487 | 0.1026 | -5.3700 | 43.5165 |

As noted in Table 5, in each Example, the resin layer precursor formed of the active energy ray-curable resin composition was irradiated with active energy rays, and then, the surface treatment was performed through the dry process, and therefore, it was possible to form the unevenness containing the wrinkle structure on the outermost surface of the laminate.

Meanwhile, in Comparative Examples 1 and 5, the resin layer was not formed or the surface treatment using the dry process was not carried out on the resin layer, and therefore, the unevenness containing the wrinkle structure was not formed on the outermost surface of the laminate.

In addition, as is clear from the comparison of Examples 25 to 28, it is possible to control the size of the unevenness and to form the unevenness structure suitable for various applications (adhesion prevention, light transmission, etc.) in which the fine unevenness on the surface is utilized according to the presence or absence of blending of the active energy ray polymerization initiator, and the difference in the dry process. In Examples 25 and 26, since a small amount of the active energy ray polymerization initiator was contained, the stickiness on the surface of the resin layer precursor after energy ray irradiation was slight, and thus the handling property was also excellent.

### <Test Example 5: Examples 29 to 36>

In Test Example 5, the wrinkle structure on the surface of the laminate in Examples 29 to 36 was observed.

### Example 29

### (Preparation of thermosetting resin composition (AC4))

To 2.12 parts by mass of the solid content of acrylpolyol (manufactured by NIPPON SHOKUBAI CO., LTD., product name "UV-G301", ethyl acetate solution with solid content of 42.4%) as a binder resin, and 0.06 parts by mass of an isocyanate-based compound (manufactured by Mitsui Chemicals, Inc., product name "TAKENATE D-165N", hexamethylenediisocyanate-based compound, solid content 100%) as a curing agent, ethyl acetate as a solvent was added such that the solid content concentration became 21.83% by mass, followed by mixing, and thereby, a diluted solution of the thermosetting resin composition (AC4) was prepared.

### (Formation of resin layer precursor)

The obtained diluted solution of the thermosetting resin composition (AC4) was applied to one surface of a PET film (manufactured by Mitsubishi Chemical Corporation, product name "T100 type", thickness 188 µm) as a base material such that the thickness after curing was as noted in Table 6, and then was dried and cured by being heated at 80°C for 1 min, and thereby, a semi-cured resin layer precursor was formed. Next, immediately after it was left at room temperature (23°C) for 3 h, the CVD processing described below was started.

### (Formation of cover layer)

By using a plasma CVD device (manufactured by U-Tech Co., Ltd.), an acetylene gas was introduced, the partial pressure was set as 1 Pa, and CVD was performed with power of 500 W under a vacuum of 1 Pa, so that an inorganic substance-containing layer (1) (DLC layer) with a thickness of 90 nm was formed on the semi-cured resin layer precursor, and a laminate having a stacked structure of base material/resin layer/cover layer was obtained.

### Examples 30 to 36

These were carried out in the same manner as in Example 29 except that the blending of the thermosetting resin composition was changed as noted in Table 6.

**Table 6**

| | | | Example 29 | Example 30 | Example 31 | Example 32 | Example 33 | Example 34 | Example 35 | Example 36 |
|---|---|---|---|---|---|---|---|---|---|---|
| Cover layer | Film forming method | - | CVD | CVD | CVD | CVD | CVD | CVD | CVD | CVD |
| | Type | - | DLC | DLC | DLC | DLC | DLC | DLC | DLC | DLC |
| | Thickness(tₐ) | Nm | 90 | 90 | 90 | 90 | 90 | 90 | 90 | 90 |
| Resin layer | Binder resin | parts by mass | 2.12 | 2.12 | 2.12 | 2.12 | 2.12 | 2.12 | 2.12 | 0 |
| | Curing agent | parts by mass | 0.06 | 0.25 | 0.62 | 1.54 | 6.15 | 15.38 | 30.76 | 50 |
| | R | - | 0.1 | 0.4 | 1 | 2.5 | 10 | 25 | 50 | ∞ |
| | Thickness(t_{b}) | µm | 5 | 5 | 5 | 5 | 5 | 5 | 5 | 5 |
| Base materia | Type | - | PET sheet | PET sheet | PET sheet | PET sheet | PET sheet | PET sheet | PET sheet | PET sheet |
| | Thickness | µm | 188 | 188 | 188 | 188 | 188 | 188 | 188 | 188 |
| Surface roughness | Sa | nm | 262 | 257 | 287 | 450 | 837 | 1544 | 2113 | 2247 |
| | Sz | nm | 2963 | 2958 | 3291 | 4050 | 7065 | 11169 | 12871 | 13663 |
| Thickness ratio(t_{a/}t_{b}) | | - | 18 | 18 | 18 | 18 | 18 | 18 | 18 | 18 |
| Unevenness having wrinkle structure | | - | A | A | A | A | A | A | A | A |
| Presence or absence of higher-order wrinkle structure | | - | B | B | B | A | A | A | A | A |
| Specific surface area | S/A | - | 1.0623 | 1.0618 | 1.0656 | 1.0676 | 1.1217 | 1.2071 | 1.2114 | 1.2087 |
| Degree of deviation | Ssk | - | 0.0656 | 0.0270 | 0.0123 | -0.1011 | -0.0275 | 0.0318 | 0.3233 | 0.5217 |

As noted in Table 6, the laminate in Examples 29 to 31 had only a primary wrinkle structure whereas the laminate in Examples 32 to 36 had an unevenness containing a primary wrinkle structure, and a secondary wrinkle structure having a smaller undulation period than the primary wrinkle structure (hierarchical unevenness structure). From Examples 29 to 36, it can be found that it is possible to easily control the unevenness by adjusting the blending ratio of the binder resin and the curing agent in the resin layer.

### Reference Signs List

10: laminate, 10A: outermost surface of laminate, 11: base material, 11A: one surface of base material, 12: resin layer, 13: cover layer, 14: over cover layer

## Claims

1. A laminate comprising a base material, and a resin layer provided on at least one surface of the base material,
wherein the resin layer is formed of a heat- or active energy ray-curable resin composition, and
an outermost surface of the laminate on the one surface side of the base material has an unevenness containing a wrinkle structure.

2. The laminate according to claim 1, wherein the resin layer buckles to form the wrinkle structure.

3. The laminate according to claim 1 or 2, wherein a specific surface area (S/A) of the outermost surface is 1.005 or more.

4. The laminate according to any one of claims 1 to 3, wherein Sa (arithmetic mean roughness) of the outermost surface is 50 nm or more.

5. The laminate according to any one of claims 1 to 4, wherein Sz (maximum height) of the outermost surface is 4000 nm or more.

6. The laminate according to any one of claims 1 to 5, wherein an absolute value of Ssk (degree of deviation) of the outermost surface is 5 or less.

7. The laminate according to any one of claims 1 to 6, further comprising a cover layer on the resin layer.

8. The laminate according to any one of claims 1 to 7, wherein the cover layer is either an inorganic substance-containing layer or a cover resin layer.

9. The laminate according to claim 8, wherein the inorganic substance-containing layer is formed of at least one selected from the group consisting of diamond-like carbon, metal, metal oxide, metal nitride, metal carbide, and composites thereof.

10. The laminate according to claim 8 or 9, wherein the inorganic substance-containing layer is formed of a silicon-based compound.

11. The laminate according to any one of claims 7 to 10, wherein the cover layer contains a fluorine-based compound on at least a surface thereof.

12. The laminate according to any one of claims 1 to 11, wherein the wrinkle structure includes a primary wrinkle structure, and a secondary wrinkle structure having a smaller undulation period than the primary wrinkle structure.

13. A method of manufacturing a laminate, the method comprising:
applying a heat- or active energy ray-curable resin composition to at least one surface of a base material to form a resin layer precursor; and
further performing a surface treatment through a dry process to the resin layer precursor that is semi-cured or uncured, thereby forming an unevenness containing a wrinkle structure on a surface on the one surface side of the base material.

14. The laminate manufacturing method according to claim 13, wherein the surface treatment is any of chemical vapor deposition, physical vapor deposition, and plasma treatment.

15. The laminate manufacturing method according to claim 13 or 14, further comprising semi-curing the resin layer precursor formed by the applying,
wherein the surface treatment is performed to the semi-cured resin layer precursor.
